# EUROPEAN PATENT APPLICATION

(11) **EP 4 239 695 A1**
(43) Date of publication of application: **06.09.2023**
(21) Application number: 23159146.2
(22) Date of filing: 28.02.2023
(51) Int. Cl.: H01L 33/00, H01L 33/16, H01L 33/18, H01L 33/20, H01L 33/24, H01L 33/44

(54) **LIGHT EMITTING ELEMENT AND METHOD OF MANUFACTURING THE LIGHT EMITTING ELEMENT**

(30) Priority: 02.03.2022 KR 20220026872
(71) Applicant: Samsung Display Co., Ltd., Yongin-si, Gyeonggi-do 17113 (KR)
(72) Inventor: SONG, Young Jin, 17113 Yongin-si (KR); KIM, Jin Wan, 17113 Yongin-si (KR); KIM, Sang Jo, 17113 Yongin-si (KR); LEE, Seung Geun, 17113 Yongin-si (KR)
(74) Representative: Marks & Clerk LLP

(57) **Abstract**

A light emitting element is capable of increasing light emission efficiency. The light emitting element includes a first semiconductor layer including a groove and a protrusion disposed around the groove, a light emitting layer disposed on the groove of the first semiconductor layer and having a shape corresponding to the groove, a second semiconductor layer disposed on the light emitting layer, and an insulating pattern layer disposed on the protrusion of the first semiconductor layer and surrounding the second semiconductor layer.

## Description

### BACKGROUND

### 1. Technical Field

Embodiments relate to a light emitting element, a display device including the light emitting element, and a method of manufacturing the light emitting element.

### 2. Description of the Related Art

Recently, demand for display devices has been increased in various technical fields. Accordingly, research and development of a display device has been continuously conducted.

### SUMMARY

Embodiments provide a light emitting element capable of increasing light emission efficiency, a display device including the light emitting element, and a method of manufacturing the light emitting element.

However, embodiments of the disclosure are not limited to those set forth herein. The above and other embodiments will become more apparent to one of ordinary skill in the art to which the disclosure pertains by referencing the detailed description of the disclosure given below.

According to an embodiment, a light emitting element includes a first semiconductor layer including a groove and a protrusion disposed around the groove, a light emitting layer disposed on the groove of the first semiconductor layer and having a shape corresponding to the groove, a second semiconductor layer disposed on the light emitting layer, and an insulating pattern layer disposed on the protrusion of the first semiconductor layer and surrounding the second semiconductor layer.

In an embodiment, the insulating pattern layer may entirely surround the light emitting layer and the second semiconductor layer in a plan view.

In an embodiment, the light emitting layer may be disposed at a height equal to or less than a maximum height of the groove with respect to a lower surface of the first semiconductor layer.

In an embodiment, the second semiconductor layer and the insulating pattern layer may have the same height with respect to a lower surface of the first semiconductor layer.

In an embodiment, the second semiconductor layer may have a height equal to or greater than a maximum height of the insulating pattern layer with respect to a lower surface of the first semiconductor layer, and a portion of the second semiconductor layer may be disposed on the insulating pattern layer.

In an embodiment, the insulating pattern layer may entirely surround a remaining portion of the second semiconductor layer.

In an embodiment, the first semiconductor layer and the second semiconductor layer may be separated from each other by at least one of the light emitting layer and the insulating pattern layer between the first semiconductor layer and the second semiconductor layer.

In an embodiment, the groove may include a first surface parallel to a lower surface of the first semiconductor layer, and a second surface protruding from the first surface of the groove toward an upper surface of the first semiconductor layer.

In an embodiment, the second surface of the groove may include an inclined surface inclined at an angle of less than 90 degrees with respect to the first surface of the groove.

In an embodiment, the second surface of the groove may be perpendicular (*e.g.* substantially perpendicular) to the first surface of the groove.

In an embodiment, at least one of the first surface and the second surface of the groove may include a curved surface.

In an embodiment, the groove may have a V-shaped cross section.

In an embodiment, the groove may have a curved shape in an entire area of the groove.

In an embodiment, the light emitting element may further include at least one of a third semiconductor layer disposed between the first semiconductor layer and the light emitting layer, and a fourth semiconductor layer disposed between the light emitting layer and the second semiconductor layer.

In an embodiment, the light emitting element may further include an electrode layer disposed on the second semiconductor layer and the insulating pattern layer.

In an embodiment, the light emitting element may further include an insulating film surrounding an outer circumferential surface of a light emitting stack including the first semiconductor layer, the light emitting layer, the second semiconductor layer, and the insulating pattern layer.

According to an embodiment, a display device may include a pixel including a light emitting element. The light emitting element may include a first semiconductor layer including a groove and a protrusion disposed around the groove, a light emitting layer disposed in the groove and having a shape corresponding to the groove, a second semiconductor layer disposed around the light emitting layer and separated from the first semiconductor layer by the light emitting layer between the first semiconductor layer and the second semiconductor layer, and an insulating pattern layer disposed at a position corresponding to the protrusion and surrounding the second semiconductor layer.

According to an embodiment, a method of manufacturing a light emitting element includes forming a first semiconductor layer on a substrate, forming an insulating pattern layer on a portion of the first semiconductor layer, forming a groove in the first semiconductor layer by etching another portion of the first semiconductor layer that is not covered by the insulating pattern layer, forming a light emitting layer by an epitaxial growth process in the groove, forming a second semiconductor layer on the light emitting layer, forming a mask on the second semiconductor layer and a portion of the insulating pattern layer disposed around the second semiconductor layer, patterning the light emitting element by etching the first semiconductor layer and the insulating pattern layer that are not covered by the mask, and separating the light emitting element from the substrate.

In an embodiment, the light emitting layer may be entirely surrounded by at least one of the first semiconductor layer and the insulating pattern layer disposed around the groove.

In an embodiment, the method may further include forming an electrode layer on the insulating pattern layer and the second semiconductor layer, before the forming of the mask. The forming of the mask may include forming the mask on the electrode layer overlapping the second semiconductor layer and the portion of the insulating pattern layer.

At least some of the above and other features of the invention are set out in the claims.

Embodiments provide the light emitting element including the first semiconductor layer including the groove and the protrusion, the light emitting layer disposed in the groove and having the shape corresponding to the groove, the second semiconductor layer disposed on the light emitting layer, and an insulating pattern layer disposed on the protrusion and surrounding the second semiconductor layer. In addition, embodiments provide the display device including the light emitting element, and the method of manufacturing the light emitting element.

According to embodiments, the light emitting layer may not be exposed in an etching process for individually patterning the light emitting element on a growth substrate, thereby preventing damage to the light emitting layer. In addition, as the insulating pattern layer surrounds a side surface of the second semiconductor layer, the first semiconductor layer and the second semiconductor layer may be stably separated from each other by the light emitting layer and the insulating pattern layer. Accordingly, a surface defect of the light emitting element may be prevented, thereby blocking a leakage current and increasing light emission efficiency of the light emitting element.

In addition, according to embodiments, as the light emitting layer has the shape corresponding to the groove, a volume and a surface area of the light emitting layer may increase. Accordingly, the light emission efficiency of the light emitting element may be further increased.

Additionally, in manufacturing the light emitting element according to embodiments, strain may be relieved in at least a portion of the groove, and thus a content and/or a composition ratio of a material (for example, indium (In)) that affects a color of light generated in the light emitting layer may be readily adjusted. Accordingly, a light emitting element of a desired color may be readily provided and/or manufactured.

An effect according to the embodiments is not limited by the contents illustrated above, and more various effects are included in the specification.

### BRIEF DESCRIPTION OF THE DRAWINGS

The above and other features of the disclosure will become more apparent by describing in further detail embodiments thereof with reference to the accompanying drawings, in which:
FIG. 1 is a schematic perspective view illustrating a light emitting element according to an embodiment;
FIGS. 2 and 3 are schematic cross-sectional views illustrating a light emitting element according to an embodiment;
FIGS. 4 to 12 are schematic cross-sectional views each illustrating a light emitting element according to an embodiment;
FIGS. 13 to 25 are schematic cross-sectional views illustrating a method of manufacturing a light emitting element according to an embodiment;
FIG. 26 is a schematic plan view illustrating a display device according to an embodiment;
FIGS. 27 and 28 are schematic diagrams of equivalent circuits of pixels, respectively, according to an embodiment;
FIG. 29 is a schematic plan view illustrating a pixel according to an embodiment;
FIG. 30 is a schematic cross-sectional view illustrating a display device according to an embodiment; and
FIG. 31 is a schematic enlarged cross-sectional view of one area of a pixel shown in FIG. 30.

### BRIEF DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

The disclosure may be modified in various ways and may have various forms, and specific embodiments will be illustrated in the drawings and described in detail herein. In the following description, the singular forms also include the plural forms unless the context clearly includes the singular.

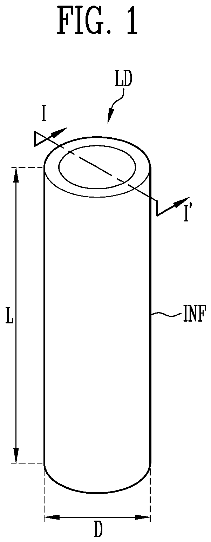

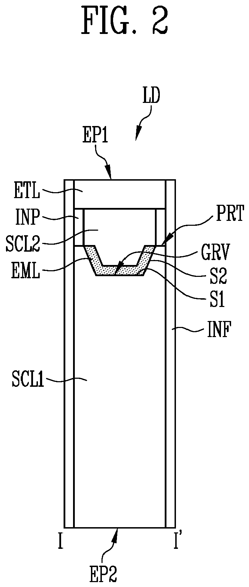

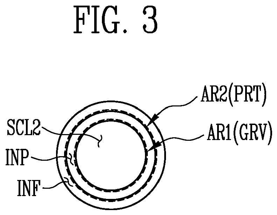

FIG. 1 is a schematic perspective view illustrating a light emitting element LD according to an embodiment. FIGS. 2 and 3 are schematic cross-sectional views illustrating a light emitting element LD according to an embodiment. For example, FIG. 2 illustrates a vertical section of the light emitting element LD, taken along line I-I' of FIG. 1, and FIG. 3 illustrates a cross section of the light emitting element LD corresponding to a portion where a second semiconductor layer SCL2 of FIG. 2 is disposed.

Referring to FIGS. 1 to 3, the light emitting element LD may include a first semiconductor layer SCL1, a light emitting layer EML, and the second semiconductor layer SCL2 sequentially disposed along a direction (for example, a length direction), and an insulating pattern layer INP overlapping a portion of the first semiconductor layer SCL1 and surrounding the second semiconductor layer SCL2. In an embodiment, the light emitting element LD may further include an insulating film INF surrounding an outer circumferential surface (for example, a side surface) of a light emitting stack including the first semiconductor layer SCL1, the light emitting layer EML, the second semiconductor layer SCL2, and the insulating pattern layer INP.

In an embodiment, the light emitting element LD may further include at least another semiconductor layer and/or at least one electrode layer. For example, the light emitting element LD may further include an electrode layer ETL disposed on a first end EP1 of the light emitting element LD to be disposed on the second semiconductor layer SCL2 and the insulating pattern layer INP. In the light emitting element LD including the electrode layer ETL, the insulating film INF may or may not at least partially surround an outer peripheral surface (for example, a side surface) of the electrode layer ETL. For example, according to an embodiment, the light emitting element LD may further include another electrode layer disposed around the first semiconductor layer SCL1. For example, the light emitting element LD may further include another electrode layer disposed on the second end EP2.

The light emitting element LD may be formed in a rod shape extending in a direction, and may have the first end EP1 and the second end EP2 at both ends (e.g., opposite ends) in a length direction (or a thickness direction). The first end EP1 may include a top surface (or an upper surface) and/or a peripheral area (or side surface) of the light emitting element LD, and the second end EP2 may include a bottom surface (or a lower surface) and/or a peripheral area (or side surface) of the light emitting element LD.

In describing an embodiment, the rod shape may include various types of rod-like shape or bar-like shape, including a cylindrical shape, a polygonal column shape, or the like, a shape of a cross section thereof is not limited thereto. A length L of the light emitting element LD having the rod shape may be greater than a diameter D (or a width of a cross section) thereof. For example, the shape of the light emitting element LD may be variously changed or modified.

The first semiconductor layer SCL1, the light emitting layer EML, the second semiconductor layer SCL2, and the electrode layer ETL may be sequentially disposed in a direction from the second end EP2 to the first end EP1 of the light emitting element LD. For example, the electrode layer ETL and/or the second semiconductor layer SCL2 may be disposed at the first end EP1 of the light emitting element LD, and the first semiconductor layer SCL1 and/or at least another electrode layer connected (e.g., electrically connected) to the first semiconductor layer SCL1 may be disposed at the second end EP2 of the light emitting element LD.

The light emitting layer EML may be disposed between the first semiconductor layer SCL1 and the second semiconductor layer SCL2. The insulating pattern layer INP may be disposed on a portion of the first semiconductor layer SCL1 and may at least partially surround a side surface of the second semiconductor layer SCL2.

In an embodiment, the first semiconductor layer SCL1 includes a groove GRV and a protrusion PRT. For example, the groove GRV may be recessed toward the lower surface of the light emitting element LD, and the protrusion PRT may be protruded toward the upper surface of the light emitting element LD. The light emitting layer EML is disposed in the groove GRV (or on the groove GRV) of the first semiconductor layer SCL1, and the insulating pattern layer INP is disposed on the protrusion PRT of the first semiconductor layer SCL1 (e.g., in the length direction). In an embodiment, a portion of the second semiconductor layer SCL2 may be disposed in the groove GRV together with the light emitting layer EML.

The first semiconductor layer SCL1 may include a first conductivity type semiconductor layer including a first conductivity type dopant. For example, the first semiconductor layer SCL1 may be an N-type semiconductor layer doped with an N-type dopant.

In an embodiment, the first semiconductor layer SCL1 may include a nitride-based semiconductor material or a phosphide-based semiconductor material. For example, the first semiconductor layer SCL1 may include a nitride-based semiconductor material including at least one of GaN, AlGaN, InGaN, InGaAlN, AlN, and InN, or may include a phosphide-based semiconductor material including at least one of GaP, GaInP, AlGaP, AlGaInP, AlP, and InP. In an embodiment, the first semiconductor layer SCL1 may include an N-type dopant such as Si, Ge, or Sn. A material of the first semiconductor layer SCL1 is not limited thereto, and the first semiconductor layer SCL1 may be formed of various other materials.

The first semiconductor layer SCL1 may include the groove GRV and the protrusion PRT around (or surrounding) the groove GRV. For example, the first semiconductor layer SCL1 may include the groove GRV and the protrusion PRT on a first surface (for example, an upper surface) adjacent to the light emitting layer EML and the second semiconductor layer SCL2. Accordingly, the first semiconductor layer SCL1 may have a surface that is not flat on the first surface.

On the cross section of the light emitting element LD, the groove GRV may be disposed in a first area (or a first portion) AR1 of a position corresponding to a central area (or a central portion) of the first semiconductor layer SCL1, and the protrusion PRT may be disposed in a second area (or a second portion) AR2 of a position corresponding to an edge area of the first semiconductor layer SCL1. In an embodiment, on the cross section (or a plan view) of the light emitting element LD, the second area AR2 may surround (e.g., completely or entirely surround) the first area AR1, and the protrusion PRT may surround (e.g., completely or entirely surround) the groove GRV.

In an embodiment, the groove GRV may include a first surface S1 corresponding to a bottom surface and a second surface S2 corresponding to a sidewall. In an embodiment, the first surface S1 of the groove GRV may be substantially parallel to a second surface (for example, a bottom surface) of the first semiconductor layer SCL1 and may be substantially flat. The second surface S2 of the groove GRV may protrude in a height direction (for example, the length or thickness direction of the light emitting element LD) from the first surface S1 of the groove GRV.

In an embodiment, the second surface S2 of the groove GRV may include an inclined surface inclined at an angle of less than 90 degrees with respect to the first surface S1. For example, the light emitting layer EML may be smoothly formed (for example, epitaxially grown) also on the second surface S2 of the groove GRV. For example, on a substrate (e.g., a growth substrate) on which the first semiconductor layer SCL1 is grown, strain may be alleviated on the second surface S2 of the groove GRV compared to the first surface S1 corresponding to a C-plane, and thus a content and/or a composition ratio of a specific material, for example, indium (In), included in the light emitting layer EML in a formation process of the light emitting layer EML may be readily controlled. For example, on the second surface S2, a color shift phenomenon according to a quantum-confined stark effect (QCSE) that may occur on the first surface S1 may not occur. Accordingly, a color of light generated in the light emitting layer EML may be readily controlled, and a light emitting element LD of a desired color may be provided and/or manufactured.

The light emitting layer EML (also referred to as an "active layer") may include a single or multiple quantum well (QW) structure. In the case that a voltage equal to or greater than a threshold voltage is applied to both ends (e.g., opposite ends) of the light emitting element LD, light may be emitted in the case that an electron-hole pair is recombined in the light emitting layer EML. In the case that an electric signal is applied to the light emitting layer EML through the first semiconductor layer SCL1 and the second semiconductor layer SCL2, light of a specific color and a wavelength band corresponding thereto may be emitted in the case that the electron-hole pair is recombined in the light emitting layer EML.

In an embodiment, the light emitting layer EML may emit light of a visible light wavelength band, for example, light having a wavelength of about 400 nm to about 900 nm. For example, the light emitting layer EML may emit blue light having a wavelength of a range of about 450 nm to about 480 nm, green light having a wavelength of a range of about 480 nm to about 560 nm, or red light having a wavelength of a range of about 620 nm to about 750 nm. For example, the color and/or the wavelength band of the light generated in the light emitting layer EML may be changed or modified.

In an embodiment, the light emitting layer EML may include a nitride-based semiconductor material or a phosphide-based semiconductor material. For example, the light emitting layer EML may include a nitride-based semiconductor material including at least one of GaN, AlGaN, InGaN, InGaAlN, AlN, InN, and AlInN, or may include a phosphide-based semiconductor material including at least one of GaP, GaInP, AlGaP, AlGaInP, AlP, and InP. A material of the light emitting layer EML is not limited thereto, and the light emitting layer EML may be formed of various other materials.

In an embodiment, the light emitting layer EML may generate light of a color (or a wavelength) corresponding to a content and/or a composition ratio of at least one of the materials included in the light emitting layer EML. For example, the light emitting layer EML may be formed as multiple layers having a structure in which a GaN layer and an InGaN layer are alternately stacked each other and/or repeatedly stacked, and may emit light of a specific color (or a wavelength band corresponding thereto) according to a content and/or a composition ratio of indium (In) included in the InGaN layer. For example, as the content and/or the composition ratio of indium (In) increases, the light emitting layer EML may emit light of a longer wavelength band. Therefore, the light emitting element LD of a desired (or specific) color may be manufactured by adjusting the content and/or the composition ratio of indium (In) included in the light emitting layer EML.

The light emitting layer EML may be disposed on the first semiconductor layer SCL1 to be positioned (or filled) in the groove GRV. In an embodiment, the light emitting layer EML may be surrounded (e.g., completely or entirely surrounded) by the first semiconductor layer SCL1 and/or the insulating pattern layer INP in the cross-section (or the plan view) of the light emitting element LD. For example, the light emitting layer EML may be disposed at a height equal to or less than a maximum height of the groove GRV with respect to the bottom surface of the first semiconductor layer SCL1, and may be disposed inside the groove GRV of the first semiconductor layer SCL1 so as to be surrounded (e.g., completely or entirely surrounded) by the protrusion PRT of the first semiconductor layer SCL1.

In a manufacturing process of the light emitting element LD (e.g., in an etching process for patterning the light emitting element LD in the rod shape), the light emitting layer EML may be surrounded by the first semiconductor layer SCL1, the insulating pattern layer INP, and/or, and may not be exposed to the outside. Accordingly, damage to the light emitting layer EML may be prevented, and a surface defect of the light emitting element LD may be prevented or reduced. Accordingly, a leakage current due to the surface defect or the like of the light emitting element LD may be blocked or reduced, and light emission efficiency of the light emitting element LD may be increased.

The light emitting layer EML has a shape corresponding to (or overlapping) the groove GRV. For example, the light emitting layer EML may continuously extend along the first and second surfaces S1 and S2 of the groove GRV. For example, the light emitting layer EML may be recessed along the groove GRV. For example, a portion of the light emitting layer EML may be disposed on the first surface S1 of the groove GRV to have a surface profile corresponding to the first surface S1, and another portion of the light emitting layer EML may be disposed on the second surface S2 of the groove GRV to have a surface profile corresponding to the second surface S2. For example, the light emitting layer EML may have a three-dimensional shape that is not flat. For example, the light emitting layer EML may be recessed corresponding to a shape of the groove GRV. It is assumed that the size of an area in which the light emitting layer EML is formed (for example, the size of a first area AR1 in which the groove GRV is formed) and a thickness condition of the light emitting layer EML are the same (or maintained) in a plan view, a volume and a surface area of the light emitting layer EML, which is formed inside of the groove GRV and has a shape that is not flat (for example, a three-dimensional shape), may be increased compared to a case where the light emitting layer EML has a flat shape (for example, a two-dimensional shape). Accordingly, the electron-hole pair recombined in the light emitting layer EML may increase, and a light emission amount of and/or light emission efficiency of the light emitting element LD may increase. For example, as the light emitting layer EML has a three-dimensional shape corresponding to the groove GRV, the light emission amount and/or the light emission efficiency of the light emitting element LD may increase.

The second semiconductor layer SCL2 is disposed on the light emitting layer EML. In an embodiment, a portion of the second semiconductor layer SCL2 may be disposed in the groove GRV together with the light emitting layer EML, and another portion of the second semiconductor layer SCL2 may protrude above the groove GRV. A shape and/or a size of the second semiconductor layer SCL2 may be variously changed or modified.

The second semiconductor layer SCL2 may include a second conductivity type semiconductor layer including a second conductivity type dopant. For example, the second semiconductor layer SCL2 may be a P-type semiconductor layer doped with a P-type dopant.

In an embodiment, the second semiconductor layer SCL2 may include a nitride-based semiconductor material or a phosphide-based semiconductor material. For example, the second semiconductor layer SCL2 may include a nitride-based semiconductor material including at least one of GaN, AlGaN, InGaN, InGaAlN, AlN, and InN, or may include a phosphide-based semiconductor material including at least one of GaP, GaInP, AlGaP, AlGaInP, AlP, and InP. In an embodiment, the second semiconductor layer SCL2 may include a P-type dopant such as Mg. A material of the second semiconductor layer SCL2 is not limited thereto, and the second semiconductor layer SCL2 may be formed of various other materials.

In an embodiment, the first semiconductor layer SCL1 and the second semiconductor layer SCL2 may include the same semiconductor material, and may include dopants of different conductivity types. In another example, the first semiconductor layer SCL1 and the second semiconductor layer SCL2 may include different semiconductor materials and may include dopants of different conductivity types.

In an embodiment, the first semiconductor layer SCL1 and the second semiconductor layer SCL2 may have different lengths (or thicknesses) in the length direction of the light emitting element LD. For example, the first semiconductor layer SCL1 may have a length longer (or a thickness thicker) than that of the second semiconductor layer SCL2 in the length direction of the light emitting element LD. Accordingly, the light emitting layer EML may be positioned closer to the first end EP1 (for example, the P-type end) than the second end EP2 (for example, an N-type end).

The insulating pattern layer INP is disposed on the first semiconductor layer SCL1 to be positioned on the protrusion PRT of the first semiconductor layer SCL1, and surrounds the second semiconductor layer SCL2. For example, the insulating pattern layer INP may surround (e.g., completely or entirely surround) the second semiconductor layer SCL2 in the cross section of the light emitting element LD corresponding to an area (or a portion) in which the second semiconductor layer SCL2 and the insulating pattern layer INP are disposed. In an embodiment, the second semiconductor layer SCL2 may be disposed on the light emitting layer EML to overlap the light emitting layer EML, and thus the insulating pattern layer INP may surround (e.g., completely or entirely surround) the light emitting layer EML and the second semiconductor layer SCL2 in a plan view.

In an embodiment, the insulating pattern layer INP and the second semiconductor layer SCL2 may be formed at the same height. For example, the second semiconductor layer SCL2 and the insulating pattern layer INP may have the same height with respect to the bottom surface (for example, the bottom surface of the first semiconductor layer SCL1 positioned at the second end EP2 of the light emitting element LD) of the first semiconductor layer SCL1. For example, the highest height of the second semiconductor layer SCL2 and the highest height of the insulating pattern layer INP with respect to the bottom surface of the first semiconductor layer SCL1 may be substantially the same. An interface between the second semiconductor layer SCL2 and the insulating pattern layer INP, and the electrode layer ETL thereon may be substantially flat. For example, the electrode layer ETL may be readily patterned, and the electrode layer ETL may be formed to be substantially flat. For example, the light emitting element LD may have a flat surface at the first end EP1 thereof. For example, the light emitting element LD may have a flat surface at both of the first end EP1 and the second end EP2. For example, a contact process or the like for electrically connecting the light emitting element LD to another electrode, line, element, and/or the like may be performed more readily and/or stably.

The insulating pattern layer INP may include at least one organic insulating material and/or at least one inorganic insulating material, and may be formed as a single layer or multiple layers. For example, although the insulating pattern layer INP is shown as a single layer in FIG. 2, the insulating pattern layer INP may be formed as multiple layers of two or more layers including at least two insulating layers overlapping each other according to an embodiment.

In an embodiment, the insulating pattern layer INP may include a heat-resistant inorganic insulating material capable of withstanding a high-temperature process (for example, an MOCVD process or the like) that may be performed after formation of the insulating pattern layer INP. For example, the insulating pattern layer INP may be formed of at least one inorganic insulating material among silicon oxide (SiOₓ) (for example, SiO₂), silicon nitride (SiNₓ) (for example, Si₃N₄), and aluminium oxide (AlₓO_{y}) (for example, Al₂O₃), or various other insulating materials. In an embodiment, in the case that the insulating pattern layer INP is formed as multiple layers of double layers or triple or more layers including at least two insulating layers, insulating layers including the at least one inorganic insulating material and/or at least another insulating material may be formed as double layers or triple or more layers.

The electrode layer ETL may be disposed on the second semiconductor layer SCL2 and the insulating pattern layer INP. The electrode layer ETL may be an electrode for protecting the second semiconductor layer SCL2 and for smoothly connecting the second semiconductor layer SCL2 to an electrode or line (e.g., a predetermined electrode or line). For example, the electrode layer ETL may be an ohmic contact electrode or a Schottky contact electrode.

In an embodiment, the electrode layer ETL may include a metal or a metal oxide. For example, the electrode layer ETL may be formed of a metal such as chromium (Cr), titanium (Ti), aluminium (Al), gold (Au), nickel (Ni), or copper (Cu), an oxide or an alloy thereof, a transparent conductive material such as indium tin oxide (ITO), indium zinc oxide (IZO), indium tin zinc oxide (ITZO), zinc oxide (ZnO), or indium oxide (In₂O₃), and the like alone or in combination. A material of the electrode layer ETL is not limited thereto, and the electrode layer ETL may be formed of various other materials.

In an embodiment, the electrode layer ETL may be substantially transparent. Accordingly, light generated from the light emitting element LD may pass through the electrode layer ETL and may be emitted from the first end EP1 of the light emitting element LD.

The insulating film INF may be disposed on a surface of the light emitting element LD to surround the outer circumferential surface (for example, the side surface) of the light emitting stack including the first semiconductor layer SCL1, the light emitting layer EML, the second semiconductor layer SCL2, the insulating pattern layer INP, and/or the electrode layer ETL.

The insulating film INF may expose the electrode layer ETL (or the second semiconductor layer SCL2) and the first semiconductor layer SCL1 (or another electrode layer disposed at the second end EP2 of the light emitting element LD), respectively, at the first end EP1 and the second end EP2 of the light emitting element LD. For example, the insulating film INF may not be disposed on two lower surfaces corresponding to the first end EP1 and the second end EP2 of the light emitting element LD.

In the case that the insulating film INF is disposed on the surface of the light emitting element LD, a short circuit defect through the light emitting element LD may be prevented. Accordingly, electrical stability of the light emitting element LD may be secured. In the case that the insulating film INF is disposed on the surface of the light emitting element LD, a surface defect of the light emitting element LD may be minimized to improve lifespan and efficiency.

The insulating film INF may include a transparent insulating material. Accordingly, light generated in the light emitting layer EML may be emitted to the outside of the light emitting element LD through the insulating film INF. For example, the insulating film INF may include at least one insulating material among silicon oxide (SiOₓ) (for example, SiO₂), silicon nitride (SiNₓ) (for example, Si₃N₄), aluminium oxide (AlₓO_{y}) (for example, Al₂O₃), titanium oxide (TiₓO_{y}) (for example, TiO₂), and hafnium oxide (HfOₓ). A material of the insulating film INF is not limited thereto, and the insulating film INF may be formed of various other materials.

The insulating film INF may be formed as a single layer or multiple layers. For example, the insulating film INF may be formed as a single layer or double or more layers. In an embodiment, in the case that the insulating film INF is formed as the multiple layers of the double or more layers including at least two insulating layers, the insulating layers including at least one insulating material and/or at least another insulating material may be formed layer by layer as double layers or triple or more layers.

In an embodiment, the insulating film INF may be partially etched (or removed) in an area (or a portion) corresponding to at least one of the first end EP1 and the second end EP2 of the light emitting element LD. For example, the insulating film INF may be etched to have a round shape at the first end EP1, but a shape of the insulating film INF is not limited thereto.

In an embodiment, the light emitting element LD may be manufactured through a surface treatment process. For example, by performing surface treatment on the light emitting elements LD by using a hydrophobic material, in the case that the light emitting elements LD are mixed with a fluid solution (hereinafter referred to as a "light emitting element mixture liquid" or a "light emitting element ink") and supplied to each emission area (for example, an emission area of the pixel), the light emitting elements LD may be uniformly dispersed in the light emitting element mixture liquid.

In an embodiment, the light emitting element LD may have a small size of a range of a nanometer (nm) to micrometer (µm). For example, each light emitting element LD may have a diameter D (or a width of a cross-section) and/or a length L of a range of a nanometer to a micrometer. For example, the light emitting element LD may have a diameter D and/or a length L of a range of approximately several tens of nanometers to several tens of micrometers. However, a size of the light emitting element LD may be changed or varied.

A structure, a shape, a size, and/or a type of the light emitting element LD may be changed or modified. For example, the light emitting element LD may be formed in another structure and/or shape, such as a core-shell structure. For example, the structure, the shape, the size, and/or the type of the light emitting element LD may be variously changed or modified according to a design condition of a light emitting device using the light emitting element LD or a light emitting characteristic to be secured.

The light emitting device including the light emitting element LD may be used in various types of devices requiring a light source. For example, the light emitting elements LD may be disposed in the pixel of the display device, and the light emitting elements LD may be used as a light source of the pixel. The light emitting element LD may also be used in another type of device that requires a light source, such as a lighting device.

As described above, the light emitting element LD includes the first semiconductor layer SCL1 including the groove GRV and the protrusion PRT, the light emitting layer EML disposed in the groove GRV and having a shape corresponding to the groove GRV, the second semiconductor layer SCL2 disposed on the light emitting layer EML, and the insulating pattern layer INP disposed on the protrusion PRT and surrounding the second semiconductor layer SCL2. Accordingly, the light emitting element LD may have high reliability and high light emission efficiency.

For example, in the etching process for individually patterning each light emitting element LD on the substrate, the light emitting layer EML may be surround (e.g., completely or entirely surrounded) by the protrusion PRT of the first semiconductor layer SCL1 and/or the insulating pattern layer INP, and thus the light emitting layer EML may be prevented from being damaged in the etching process. For example, the first semiconductor layer SCL1 and the second semiconductor layer SCL2 may be stably separated from each other by the light emitting layer EML and the insulating pattern layer INP. For example, the first semiconductor layer SCL1 and the second semiconductor layer SCL2 may be separated from each other by at least one of the light emitting layer EML and the insulating pattern layer INP interposed therebetween. Accordingly, a PN junction may be prevented from occurring between the first semiconductor layer SCL1 and the second semiconductor layer SCL2. Therefore, as described above, a surface defect of the light emitting element LD may be prevented, thereby blocking or reducing a leakage current and increasing the light emission of the light emitting element LD.

For example, as the light emitting layer EML has the shape corresponding to the groove GRV, the volume and the surface area of the light emitting layer EML may increase. Accordingly, the light emission efficiency of the light emitting element LD may be further increased.

In manufacturing the light emitting element LD, as strain is relieved in at least a portion (for example, the second surface S2) of the groove GRV, the content and/or the composition ratio of the material (for example, indium (In)) affecting (or determining) the color of the light generated in the light emitting layer EML may be readily adjusted. For example, a color shift phenomenon according to QCSE may not occur in at least a portion (for example, the second surface S2) of the groove GRV. Accordingly, the light emitting element LD that emits light of a more uniform and clear color may be provided and/or manufactured.

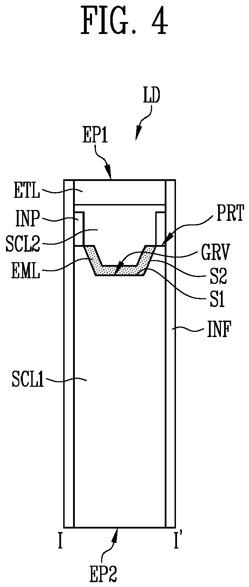

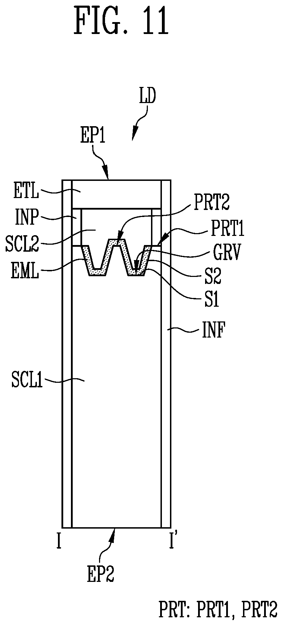

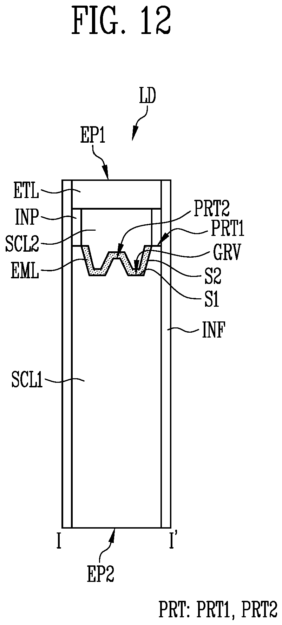

The shape of the groove GRV and the light emitting layer EML may be variously changed or modified. In the embodiments of FIGS. 4 to 10, the light emitting element LD may include the groove GRV and the light emitting layer EML of various shapes. For example, the number of grooves GRV formed in the light emitting element LD may be variously changed or modified. In the embodiments of FIGS. 11 and 12, the light emitting element LD may include two or more grooves GRV. The shape, size, number, and/or the like of the groove(s) GRV may be variously changed or modified. The light emitting element LD may have a light emitting characteristic corresponding to the shape, size, number, and/or the like of the groove(s) GRV and the light emitting layer EML.

FIGS. 4 to 12 are schematic cross-sectional views each illustrating a light emitting element LD according to an embodiment. For example, FIGS. 4 to 12 illustrate different modified examples of the embodiment of FIG. 2 corresponding to a cross section of the light emitting element LD, taken along line I-I' of FIG. 1. In describing the embodiments of FIGS. 4 to 12, the same reference numerals are given to configurations similar to or identical to those of the above-described embodiment, and a redundant description is omitted for descriptive convenience.

Referring to FIG. 4, the second semiconductor layer SCL2 may be formed to have a height higher than that of the insulating pattern layer INP. For example, the second semiconductor layer SCL2 may have a height equal to or greater than a maximum height of the insulating pattern layer INP with respect to the bottom surface of the first semiconductor layer SCL1. In an embodiment, a portion (for example, an edge area in a cross section) of the second semiconductor layer SCL2 may be disposed on the insulating pattern layer INP to overlap the insulating pattern layer INP. For example, a surface (for example, an upper surface) of the second semiconductor layer SCL2 may be substantially flat. Accordingly, an interface (or a boundary surface) between the second semiconductor layer SCL2 and the electrode layer ETL may be substantially flat. For example, the electrode layer ETL may be readily patterned.

The insulating pattern layer INP may surround (e.g., completely surround) a remaining portion of the second semiconductor layer SCL2. For example, the insulating pattern layer INP may surround (e.g., completely or entirely surround) a portion of the second semiconductor layer SCL2 positioned at the same height as the insulating pattern layer INP. Accordingly, direct bonding (or direct contact) of the first semiconductor layer SCL1 and the second semiconductor layer SCL2 may be prevented.

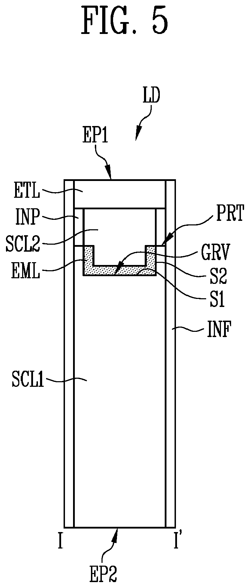

Referring to FIG. 5, the second surface S2 of the groove GRV may be substantially perpendicular to the first surface S1. For example, the groove GRV may have the second surface S2 extending vertically from the first surface S1 corresponding to a bottom surface. The second surface S2 may form a vertical sidewall of the groove GRV. For example, the second surface S2 of the groove GRV may be substantially perpendicular to the bottom surface of the first semiconductor layer SCL1.

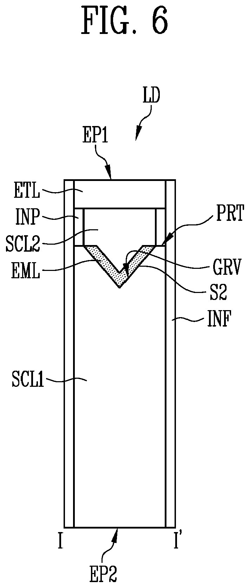

Referring to FIG. 6, the groove GRV may have a cross section of a V-shape. For example, the groove GRV may not include a bottom surface substantially, and the sidewall (for example, the second surface S2) of the groove GRV may be formed as an inclined surface inclined at an angle of less than 90 degrees with respect to the bottom surface of the first semiconductor layer SCL1.

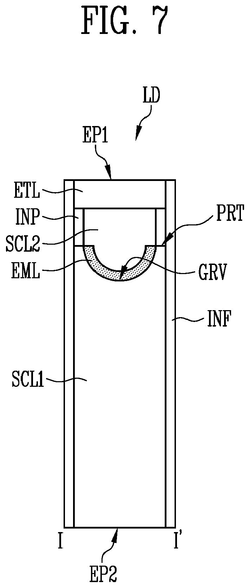

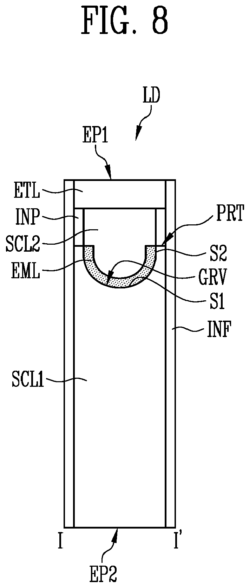

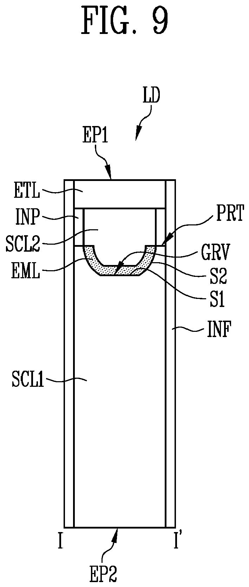

Referring to FIGS. 7 to 9, the groove GRV may include a curved surface in at least one portion. For example, as illustrated in FIG. 7, the groove GRV may have a curved shape in the entire area. In another example, the groove GRV may include the first surface S1 corresponding to the bottom surface and the second surface S2 corresponding to the sidewall, and at least one of the first surface S1 and the second surface S2 may include a curved surface. For example, only the first surface S1 of the groove GRV may have a curved shape as illustrated in FIG. 8, or only the second surface S2 of the groove GRV may have a curved shape as illustrated in FIG. 9. In another example, both of the first surface S1 and the second surface S2 of the groove GRV may include curved surfaces, and the first surface S1 and the second surface S2 may include curved surfaces of different shapes and/or curvatures.

The groove GRV may have a shape to which any one of the above-described embodiments is applied alone, or may have a shape to which at least two of the above-described embodiments are applied in combination. For example, the shape of the groove GRV may be variously changed or modified.

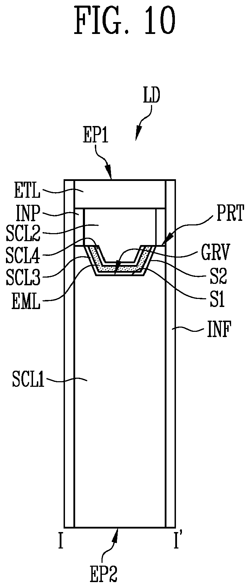

Referring to FIG. 10, the light emitting element LD may further include at least one semiconductor layer disposed on and/or under the light emitting layer EML. For example, the light emitting element LD may include at least one of a third semiconductor layer SCL3 disposed between the first semiconductor layer SCL1 and the light emitting layer EML, and a fourth semiconductor layer SCL4 disposed between the light emitting layer EML and the second semiconductor layer SCL2.

In an embodiment, the third semiconductor layer SCL3 may include a superlattice layer or a clad layer for alleviating (or reducing) strain generated between the first semiconductor layer SCL1 and the light emitting layer EML. In an embodiment, the third semiconductor layer SCL3 may include a nitride-based semiconductor material or a phosphide-based semiconductor material. For example, the third semiconductor layer SCL3 may include at least one nitride-based semiconductor material including GaN, InGaN, AlGaN, InAlGaN, or the like, or at least one phosphide-based semiconductor material including AlInP or the like. In an embodiment, the third semiconductor layer SCL3 may include a dopant (for example, an N-type dopant such as Si, Ge, or Sn).

In an embodiment, the fourth semiconductor layer SCL4 may include an electron blocking layer or clad layer for suppressing or blocking overflow of an electron that may occur between the light emitting layer EML and the second semiconductor layer SCL2. In an embodiment, the fourth semiconductor layer SCL4 may include a nitride-based semiconductor material or a phosphide-based semiconductor material. For example, the fourth semiconductor layer SCL4 may include at least one nitride-based semiconductor material including GaN, InGaN, AlGaN, InAlGaN, or the like, or at least one phosphide-based semiconductor material including AlInP or the like. In an embodiment, the fourth semiconductor layer SCL4 may include a dopant (for example, a P-type dopant such as Mg).

Referring to FIGS. 11 and 12, the light emitting element LD may include two or more grooves GRV. FIGS. 11 and 12 illustrate embodiments in which the light emitting element LD includes two grooves GRV based on a direction (for example, a horizontal direction), the number of grooves GRV included in the light emitting element LD may be changed or modified. For example, FIGS. 11 and 12 illustrate embodiments in which each groove GRV has a shape substantially identical to or similar to the groove GRV according to the embodiment of FIG. 2, the embodiments are not limited thereto. For example, the shape and/or size of each groove GRV may be changed or modified. For example, the light emitting element LD may include grooves GRV of substantially the same shape and/or size, or grooves GRV of different shapes and/or sizes.

The grooves GRV may be formed to contact or connect to (e.g., directly contact or directly connect to) each other, or may be formed to be separated from each other. In an embodiment, the first semiconductor layer SCL1 may include a first protrusion PRT1 disposed in an edge area to overlap the insulating pattern layer INP and a second protrusion PRT2 disposed inside to be positioned between the grooves GRV. The first protrusion PRT1 and the second protrusion PRT2 may be separated from each other or may be integral with each other. For example, in a plan view, the second protrusion PRT2 may extend to an edge area of the first semiconductor layer SCL1 to meet the first protrusion PRT1 or may be formed only in an inner area of the first semiconductor layer SCL1. For example, the first semiconductor layer SCL1 may include a protrusion PRT including a portion corresponding to the first protrusion PRT1 and another portion corresponding to the second protrusion PRT2, or may include two or more protrusions PRT including the first protrusion PRT1 and the second protrusion PRT2.

In an embodiment, the insulating pattern layer INP may be disposed on the first protrusion PRT1, and the insulating pattern layer INP may not be disposed on the second protrusion PRT2. For example, the insulating pattern layer INP may be disposed only on the edge area of the first semiconductor layer SCL1 to overlap the first protrusion PRT1. However, embodiments are not limited thereto. For example, in another example, the insulating pattern layer INP may also be disposed on at least a portion of the second protrusion PRT2.

In an embodiment, the first protrusion PRT1 and the second protrusion PRT2 may be formed at the same height as illustrated in FIG. 11. For example, the first protrusion PRT1 and the second protrusion PRT2 may be disposed at the same height from a bottom surface corresponding to the second end EP2 of the light emitting element LD.

In an embodiment, the first protrusion PRT1 and the second protrusion PRT2 may be at different heights as illustrated in FIG. 12. For example, the first protrusion PRT1 and the second protrusion PRT2 may be disposed at different heights from the bottom surface corresponding to the second end EP2 of the light emitting element LD. FIG. 12 illustrates an embodiment in which the second protrusion PRT2 is formed at a height lower than that of the first protrusion PRT1, but embodiments are not limited thereto.

According to the embodiments of FIGS. 4 to 12, the light emitting layer EML is disposed inside the groove GRV, and the insulating pattern layer INP is disposed to surround the second semiconductor layer SCL2 on the protrusion PRT (or the first protrusion PRT1) as illustrated in FIG. 2. Accordingly, a surface defect of the light emitting element LD may be prevented, and light emission efficiency may be increased.

For example, in at least some of the embodiments of FIGS. 4 to 12, the groove GRV may have a sidewall having an inclination of less than 90 degrees or having a curved surface. Accordingly, the light emitting layer EML may be smoothly formed (for example, epitaxially grown) also on the sidewall of the groove GRV, and the content and/or the composition ratio of indium (In) or the like may be readily adjusted, and the color shift phenomenon according to the QCSE may be prevented or reduced. Accordingly, the light emitting element LD of a desired (or specific) color may be readily provided or manufactured.

For example, in the case that the groove GRV entirely has a curved shape as illustrated in FIG. 7, a material such as indium (In) may be more uniformly distributed in the entire area of the light emitting layer EML, and the color shift phenomenon according to the QCSE may be prevented. Accordingly, the light emitting element LD that emits light of a more uniform and clear color may be provided and/or manufactured.

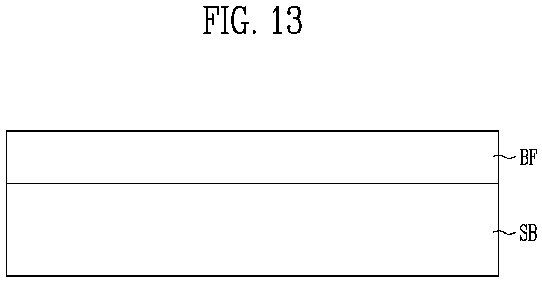

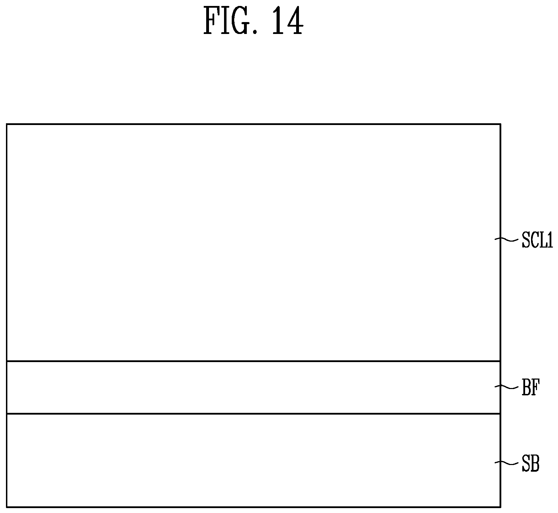

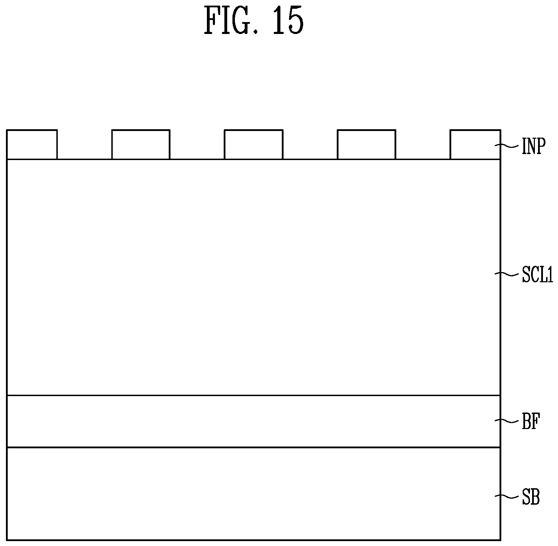

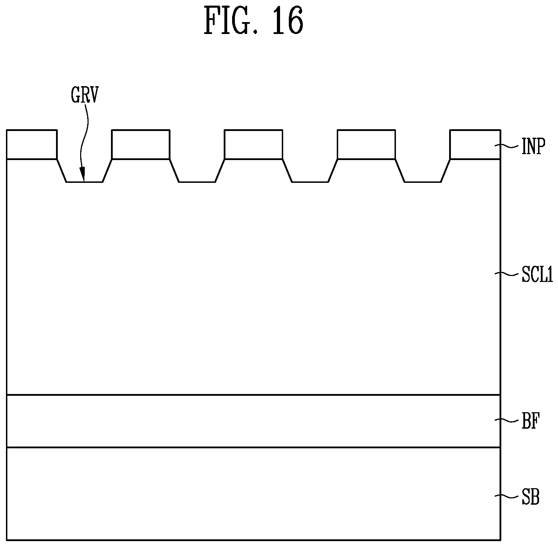

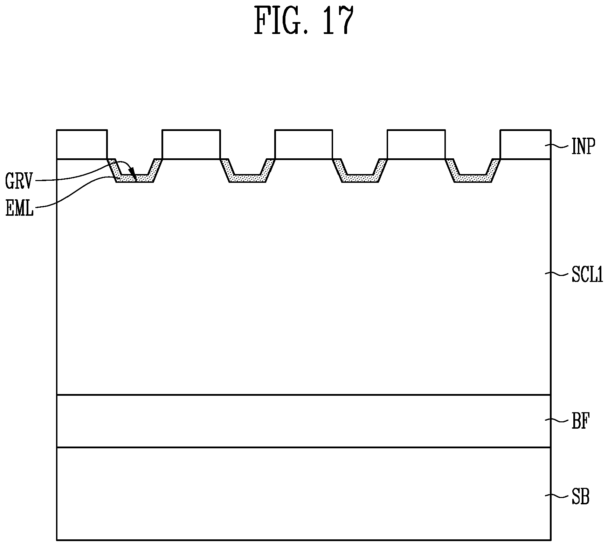

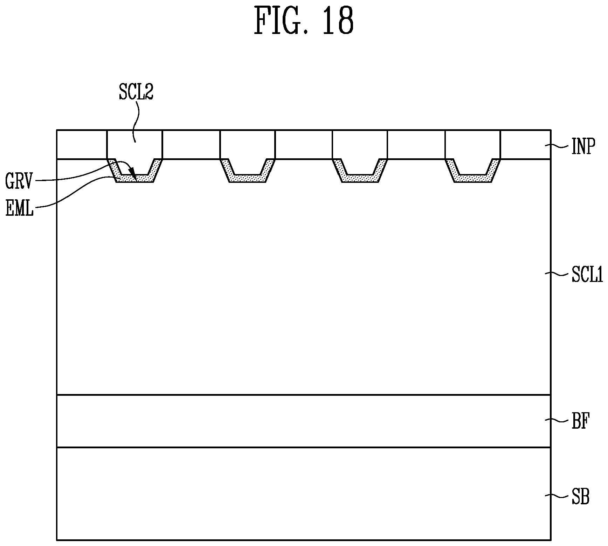

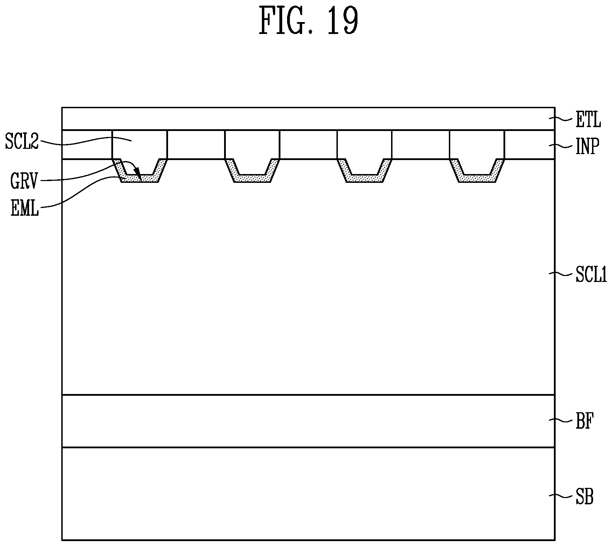

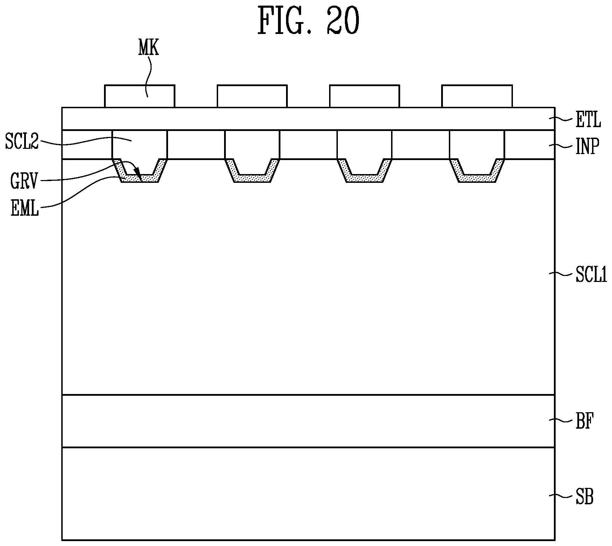

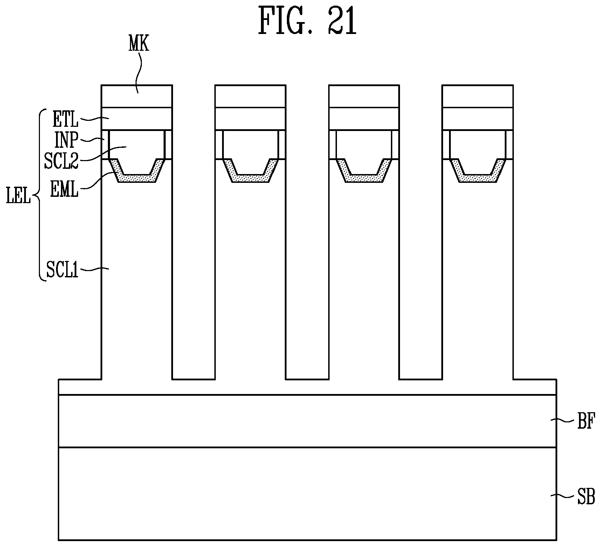

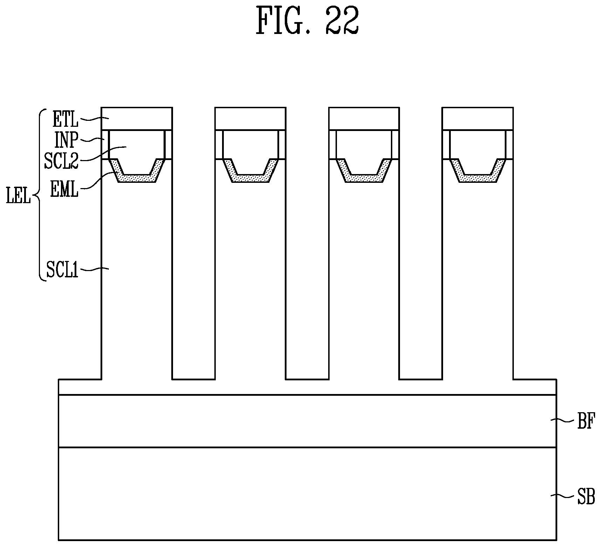

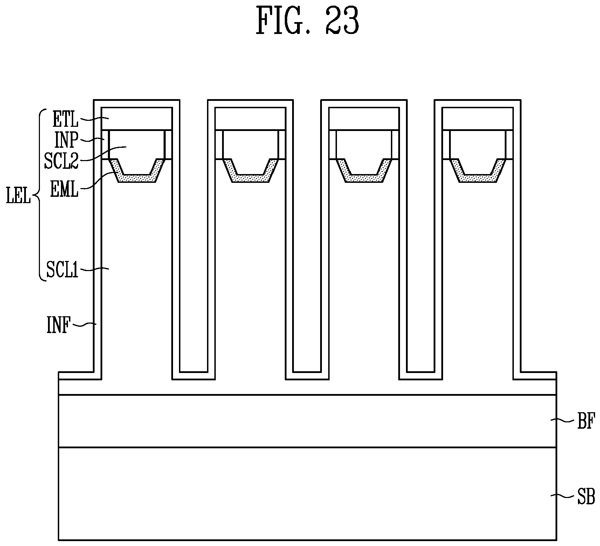

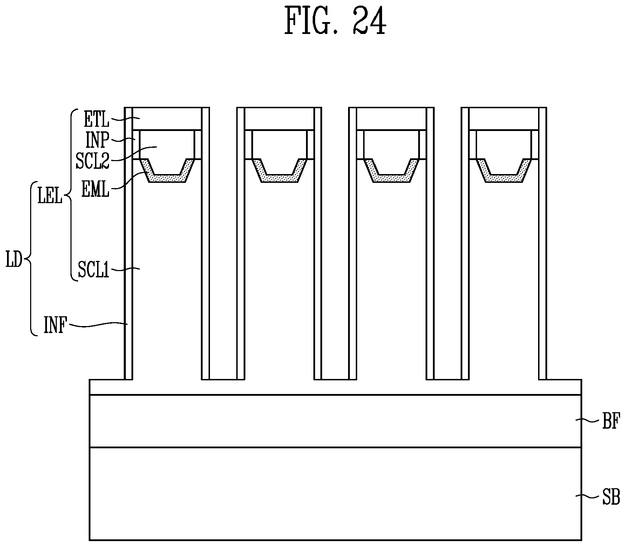

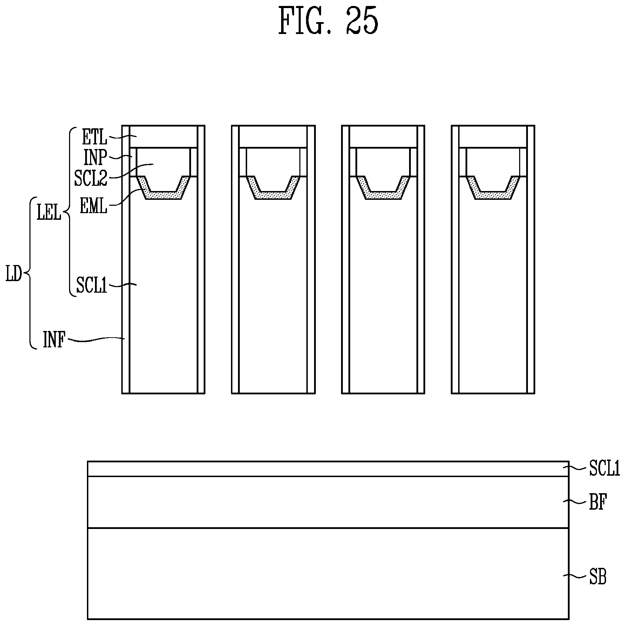

FIGS. 13 to 25 are schematic cross-sectional views illustrating a method of manufacturing a light emitting element LD according to an embodiment. For example, FIGS. 13 to 25 sequentially illustrate a method of manufacturing the light emitting element LD according to the embodiment of FIGS. 1 to 3. The light emitting element LD according to the embodiments of FIGS. 4 to 12 may be manufactured through a manufacturing method substantially identical to or similar to that of the light emitting element LD according to the embodiment of FIGS. 1 to 3. FIGS. 13 to 25 illustrate an embodiment in which light emitting elements LD are manufactured on a substrate SB.

Referring to FIGS. 1 to 13, first the substrate SB (also referred to as a "growth substrate" or a "manufacturing substrate") may be prepared or provided. In an embodiment, the buffer layer BF may be formed on the substrate SB.

The substrate SB may be a manufacturing substrate, a wafer, or the like suitable for an epitaxial growth process (or epitaxy) of a semiconductor. For example, the substrate SB may be a substrate including a material of silicon (Si), sapphire, SiC, GaN, GaAs, ZnO, or the like. For example, the substrate SB may be a substrate of various types and/or materials. In the case that selectivity (or selection ratio) for manufacturing the light emitting element LD is satisfied and an epitaxial growth process may be smoothly performed, the type or the material of the substrate SB is not limited thereto. After the substrate SB is used as the substrate for the epitaxial growth process for manufacturing the light emitting elements LD, the substrate SB may be finally separated from the light emitting elements LD.

In an embodiment, the buffer layer BF may be selectively formed on the substrate SB. The buffer layer BF may be formed on the substrate SB by an epitaxial growth process (or epitaxy), and may be finally separated from the light emitting elements LD. The buffer layer BF may be a layer positioned between the light emitting elements LD and the substrate SB to physically separate the light emitting elements LD and the substrate SB in a process of manufacturing the light emitting elements LD. The buffer layer BF may include an intrinsic semiconductor layer that is not doped with an impurity. For example, the buffer layer BF and the first semiconductor layer SCL1 may include the same semiconductor material.

In an embodiment, the buffer layer BF may include multiple layers of semiconductor layers. One of the multiple layers of semiconductor layers may be an intrinsic semiconductor layer. In an embodiment, another of the multiple layers of semiconductor layers may be doped to include a dopant of the first or second conductivity type.

In an embodiment, at least one semiconductor layer (for example, a semiconductor layer disposed on the buffer layer BF) among the multiple layers of semiconductor layers may include a nano porous structure including a porous nano pattern such as a pore. The semiconductor layer including the nano porous structure may relieve strain between the substrate SB and the first semiconductor layer SCL1 to be formed in a subsequent process. In an embodiment, the semiconductor layer including the nano porous structure may be separated from the light emitting elements LD in a process of separating the light emitting elements LD from the substrate SB and the buffer layer BF after the light emitting elements LD are manufactured on the substrate SB, and thus the semiconductor layer including the nano porous structure may not be included in the light emitting elements LD. In another example, at least a portion of the semiconductor layer including the nano porous structure may be separated from the substrate SB together with the light emitting elements LD to remain at an end (for example, the second end EP2) of each of the light emitting elements LD.

Referring to FIGS. 1 to 14, the first semiconductor layer SCL1 is formed on the substrate SB. For example, on the substrate SB on which the buffer layer BF is formed, the first semiconductor layer SCL1 may be formed by an epitaxial growth process (or epitaxy).

In an embodiment, the first semiconductor layer SCL1 may be formed of a semiconductor material of a III(Ga, Al, In)-V(P, As) group. For example, the first semiconductor layer SCL1 may be formed of at least one of the materials described as the material of the first semiconductor layer SCL1 in the embodiments of FIGS. 1 to 12, and the first semiconductor layer SCL1 may be formed of various other semiconductor materials. For example, the first semiconductor layer SCL1 may be doped to include an N-type dopant such as Si, Ge, or Sn.

The first semiconductor layer SCL1 may be formed by an epitaxial growth process using a process technology such as metal-organic vapor phase epitaxy (MOVPE), metal-organic chemical vapor deposition (MOCVD), molecular beam epitaxy (MBE), liquid phase epitaxy (LPE), or vapor phase epitaxy (VPE), but methods of forming the first semiconductor layer SCL1 are not limited thereto.

Referring to FIGS. 1 to 15, the insulating pattern layer INP is formed on a portion (hereinafter, referred to as a "first portion") of the first semiconductor layer SCL1. For example, the insulating pattern layer INP may be formed on the first portion of the first semiconductor layer SCL1 except for groove formation areas (hereinafter, referred to as a "second portion") for forming the groove GRV of each of the light emitting elements LD. For example, the insulating pattern layer INP may be formed as a connected pattern in a plan view and may include openings corresponding to the second portion of the first semiconductor layer SCL1, but a shape and/or the number of the insulating pattern layer INP may be changed or modified. In an embodiment, the insulating pattern layer INP may be formed of an inorganic insulating material capable of withstanding a subsequent high-temperature process, but materials of the insulating pattern layer INP are not limited thereto.

In an embodiment, in the case that manufacturing the light emitting element(s) LD each including two or more grooves GRV, the insulating pattern layer INP may be formed on the first portion of the first semiconductor layer SCL1 surrounding each of the groove formation areas. For example, at least one insulating pattern layer INP (for example, an insulating pattern layer INP having a mesh shape in a plan view, or insulating pattern layers INP insulated from each other) may be formed on the first portion (for example, a portion where the first and second protrusions PRT1 and PRT2 are to be formed) of the first semiconductor layer SCL1 corresponding to the first and second protrusions PRT1 and PRT2 of FIGS 11 and 12.

Referring to FIGS. 1 to 16, each groove GRV is formed by etching the second portion of the first semiconductor layer SCL1 which is not covered (or is exposed) by the insulating pattern layer INP, using the insulating pattern layer INP as a mask. For example, at least one groove GRV may be formed in each light emitting element formation area by a dry and/or wet etching process using the insulating pattern layer INP as the mask.

Each of the grooves GRV may be formed in an isotropic or anisotropic shape, and a shape of the groove GRV is not limited thereto. In an embodiment, the groove GRV may be formed in a shape substantially identical to that of any one of the embodiments of FIGS. 2 to 12, or may be formed in a shape in which at least two of the embodiments of FIGS. 2 to 12 are combined. For example, the grooves GRV may be formed in various shapes and/or numbers.

In the embodiments of FIGS. 2 to 12, in the case that at least a portion (for example, a sidewall or the like) of the groove GRV does not form C-plane, strain may be relieved in at least one portion of the groove GRV. Accordingly, in a subsequent process, a content and/or a composition ratio of a specific material included in the light emitting layer EML, for example, indium (In) that affects (or determines) a color of light, may be readily adjusted to readily manufacture the light emitting element LD of a desired color. For example, since a color shift due to QCSE may not occur in at least a portion of the groove GRV, light of a more uniform color may be emitted from the light emitting layer EML.

For example, in the case that each groove GRV includes the second surface S2 having the inclination of less than 90 degrees as illustrated in FIG. 2, 4, 6, 10, or the like, or each groove GRV includes the sidewall of the curved shape as illustrated in FIGS. 7 and 9, the light emitting layer EML may be smoothly grown also on the sidewall (or the second surface S2) of the groove GRV in a subsequent formation process of the light emitting layer EML.

As illustrated in FIG. 7, in the case that the groove GRV has the curved shape in the entire area, the light emitting layer EML may be smoothly grown in the entire area of the groove GRV, and strain may be relieved in the entire area of the groove GRV. Therefore, a material (for example, indium (In)) that affects a color of light may be more uniformly distributed in the light emitting layer EML, and color shift due to QCSE may not occur in the entire area of the light emitting layer EML. Accordingly, light of a more uniform color may be emitted from the light emitting layer EML.

In an embodiment, in the case that manufacturing the light emitting element(s) LD each including two or more grooves GRV and in which the insulating pattern layer INP is not disposed in an area (for example, an area corresponding to the second protrusion PRT2 of FIGS. 11 and 12) between the grooves GRV, a process of removing a portion of the insulating pattern layer INP (or at least one insulating pattern layer INP) positioned inside each light emitting element area may be performed.

As illustrated in of FIG. 12, in the case that the first protrusion PRT1 and the second protrusion PRT2 are to be formed at different heights, a process of etching a portion of the protrusion PRT (or at least one protrusion PRT) by a partial thickness may be performed. In the case that the second protrusion PRT2 is to be formed at a height lower than that of the first protrusion PRT1, a process of removing the insulating pattern layer INP on the second protrusion PRT2 may be performed, and a process of etching the second protrusion PRT2 by a partial thickness may be performed.

Referring to FIGS. 1 to 17, each light emitting layer EML is formed on the first semiconductor layer SCL1 to be positioned in each groove GRV. For example, the light emitting layer EML of each of the light emitting elements LD may be formed by an epitaxial growth process in each groove GRV. Accordingly, the light emitting layer EML having the shape corresponding to the shape of the groove GRV may be formed.

In an embodiment, the light emitting layer EML may be formed using at least one of the materials described as the materials of the light emitting layer EML in the embodiments of FIGS. 1 to 12, and may be formed of various other materials. In an embodiment, the light emitting layer EML may be formed by an epitaxial growth process using a process technology such as MOVPE, MOCVD, MBE, LPE, or VPE, but methods of forming the light emitting layer EML are not limited thereto.

In an embodiment, a GaN layer and an InGaN layer may be alternately and/or repeatedly formed to form the light emitting layer EML of multiple layers, and the content and/or the composition ratio of indium (In) included in the InGaN layer of the light emitting layer EML may be adjusted to form the light emitting layer EML for generating light of a desired color and/or wavelength band.

In an embodiment, the light emitting layer EML may be formed to be surrounded (e.g., completely or entirely surrounded) by at least one of the first semiconductor layer SCL1 (for example, the protrusion PRT of the first semiconductor layer SCL1) around the groove GRV and the insulating pattern layer INP. For example, the protrusion PRT of the first semiconductor layer SCL1 and the insulating pattern layer INP may surround (e.g., completely or entirely surround) each light emitting layer EML in a plan view.

In an embodiment, in the case that an additional semiconductor layer (for example, the third semiconductor layer SCL3 of FIG. 10) is formed between the first semiconductor layer SCL1 and the light emitting layer EML, a formation process of the third semiconductor layer SCL3 may be performed prior to formation of the light emitting layer EML. For example, after the third semiconductor layer SCL3 is formed by an epitaxial growth process in each groove GRV, the light emitting layer EML may be formed on the third semiconductor layer SCL3.

In an embodiment, in the case that an additional semiconductor layer (for example, the fourth semiconductor layer SCL4 of FIG. 10) is formed between the light emitting layer EML and the second semiconductor layer SCL2, a process for forming the fourth semiconductor layer SCL4 on the light emitting layer EML may be performed after the formation of the light emitting layer EML. For example, after the light emitting layer EML is formed, the fourth semiconductor layer SCL4 may be formed by epitaxial growth.

Referring to FIGS. 1 to 18, each second semiconductor layer SCL2 is formed on each light emitting layer EML. For example, each second semiconductor layer SCL2 may be formed on each light emitting layer EML by epitaxial growth.

In an embodiment, the second semiconductor layer SCL2 may be formed of at least one of the materials described as the material of the second semiconductor layer SCL2 in the embodiments of FIGS. 1 to 12, and may be formed of various other materials. For example, the second semiconductor layer SCL2 may be doped to include a P-type dopant such as Mg. In an embodiment, the second semiconductor layer SCL2 may be formed by an epitaxial growth process using a process technology such as MOVPE, MOCVD, MBE, LPE, or VPE, but methods of forming the second semiconductor layer SCL2 are not limited thereto.

In an embodiment, the second semiconductor layer SCL2 may be formed to be surrounded (e.g., completely or entirely surrounded) by the light emitting layer EML and the insulating pattern layer INP. For example, a portion except for an upper surface (or an upper layer portion) of the second semiconductor layer SCL2 may be surrounded (e.g., completely or entirely surrounded) by the light emitting layer EML and the insulating pattern layer INP.

In an embodiment, after formation of the second semiconductor layer SCL2, a planarization process for planarizing an upper surface on which the insulating pattern layer INP and the second semiconductor layer SCL2 are formed may be selectively performed. For example, the insulating pattern layer INP and the second semiconductor layer SCL2 may be formed at the same height by a planarization process using a process technology such as CMP. In another example, the insulating pattern layer INP and the second semiconductor layer SCL2 may be formed at substantially the same height without performing a separate planarization process as an epitaxial growth height of the second semiconductor layer SCL2 is adjusted. In another example, the insulating pattern layer INP and the second semiconductor layer SCL2 may not be formed at the same height. For example, as the embodiment of FIG. 4, the second semiconductor layer SCL2 may be formed to cover the insulating pattern layer INP.

Referring to FIGS. 1 to 19, the electrode layer ETL may be formed on the insulating pattern layer INP and the second semiconductor layer SCL2. For example, the electrode layer ETL may be formed on a surface (for example, an upper surface) of the substrate SB on which the insulating pattern layer INP and the second semiconductor layer SCL2 are formed. In an embodiment, the electrode layer ETL may be formed of at least one of the materials described as the material of the electrode layer ETL in the embodiments of FIGS. 1 to 12, and may be formed of various other materials. In another example, in the case that the light emitting element LD does not include the electrode layer ETL, a process of forming the electrode layer ETL may be omitted.

Referring to FIGS. 1 to 20, a mask MK is formed on the second semiconductor layer SCL2 and a portion of the insulating pattern layer INP positioned around (or surrounding) the second semiconductor layer SCL2. In the case that the light emitting element LD includes the electrode layer ETL, the mask MK may be formed on the electrode layer ETL in an area where the electrode layer ETL overlaps the second semiconductor layer SCL2 and a portion of the insulating pattern layer INP positioned around (or surrounding) the second semiconductor layer SCL2. In an embodiment, the mask MK may be formed by using a process technology such as an imprint process (for example, a nanoimprint lithography process) or a photolithography process, but methods of forming the mask MK are not limited thereto.

Referring to FIGS. 1 to 21, each light emitting element LD is patterned by etching the first semiconductor layer SCL1, the insulating pattern layer INP, and/or the electrode layer ETL by using the mask MK. For example, a light emitting stack LEL including each of the first semiconductor layer SCL1, the light emitting layer EML, the second semiconductor layer SCL2, the insulating pattern layer INP, and/or the electrode layer ETL may be etched in a rod shape, by etching the first semiconductor layer SCL1, the insulating pattern layer INP, and the electrode layer ETL in a vertical direction (or a thickness direction) in an area which is not covered by the mask MK through a dry etching process or the like. An etching process method for patterning the light emitting element LD is not limited thereto.

In an embodiment, the light emitting stack LEL may be etched in a rod shape by etching the first semiconductor layer SCL1 in a vertical direction by a thickness corresponding to a remaining portion except for a portion corresponding to a lower layer and by etching the insulating pattern layer INP and the electrode layer ETL in the vertical direction by the entire thickness.

In an embodiment, each light emitting stack LEL may be etched to have a diameter (or a width of a cross section) and/or a length of a range of a nanometer to a micrometer. Accordingly, the light emitting elements LD each having a size of a nano or micro scale may be manufactured.

In an embodiment, an etching process may be performed in a state in which the light emitting layer EML is surrounded (e.g., completely or entirely surrounded) by the first semiconductor layer SCL1 (for example, the protrusion PRT of the first semiconductor layer SCL1) around (or surrounding) the groove GRV, the insulating pattern layer INP, and/or the like. Accordingly, the light emitting layer EML may be prevented from being damaged in the etching process and a surface defect of the light emitting element LD may be prevented.

Referring to FIGS. 1 to 22, the mask MK may be removed after the etching process is completed. In an embodiment, the mask MK may be removed by a wet etching process, but process methods that may be used to remove the mask MK are not limited thereto.

Referring to FIGS. 1 to 23, the insulating film INF may be formed on a surface (for example, the upper surface) of the substrate SB including the light emitting stacks LEL. In an embodiment, the insulating film INF may be formed of at least one of the materials described as the material of the insulating film INF in the embodiments of FIGS. 1 to 12, and may be formed of various other materials. In an embodiment, the insulating film INF may be formed by using a process technology such as an atomic layer deposition (ALD) process, but methods of forming the insulating film INF are not limited thereto.

Referring to FIGS. 1 to 24, the insulating film INF may be etched to expose an upper surface of the electrode layer ETL. Accordingly, the light emitting elements LD including each light emitting stack LEL and the insulating film INF may be manufactured. The insulating film INF on an upper surface of the first semiconductor layer SCL1 between the light emitting stacks LEL may also be etched.

Referring to FIGS. 1 to 25, the light emitting elements LD are separated from the substrate SB. In an embodiment, the light emitting elements LD may be separated from the substrate SB by an electrical and/or chemical etching method or various other methods.

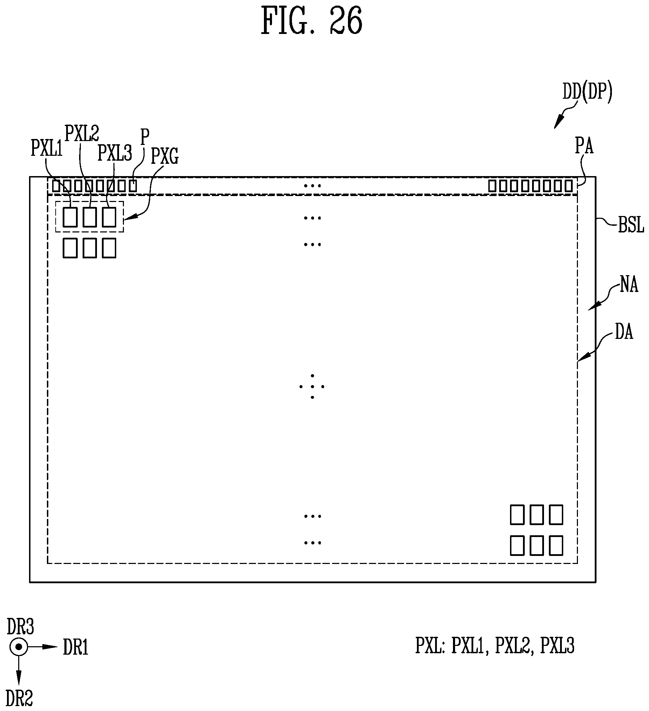

FIG. 26 is a schematic plan view illustrating a display device DD according to an embodiment. In FIG. 26, a structure of the display device DD is shown based on a display panel DP including a display area DA. The display device DD may further include a driving circuit (for example, a scan driver, a data driver, a timing controller, and the like) for driving the pixels PXL.

Referring to FIGS. 1 to 26, the display device DD may include a base layer BSL and the pixels PXL disposed on the base layer BSL. The base layer BSL and the display device DD including the base layer BSL may be formed in various shapes. For example, the base layer BSL and the display device DD may be formed in a form of a plate having a substantially quadrangular shape in a plan view, and may include an angled or rounded corner portion. A shape of the base layer BSL and the display device DD may be changed or varied. For example, the base layer BSL and the display device DD may have another polygonal shape such as a hexagon or an octagon in a plan view, or may have a shape including a curved perimeter such as a circle or an ellipse.

In FIG. 26, the display device DD is shown as having a plate shape of a quadrangular shape. For example, a traverse direction (for example, a row direction or a horizontal direction) of the display device DD is defined as a first direction DR1, a height direction (for example, a column direction or a vertical direction) of the display device DD is defined as a second direction DR2, and a thickness direction (or a height direction) of the display device DD is defined as a third direction DR3.

The base layer BSL may be a base member for forming the display device DD. For example, the base layer BSL may form a base surface of the display device DD.

The base layer BSL and the display device DD including the base layer BSL may include a display area DA for displaying an image, and a non-display area NA positioned around (or surrounding) the display area DA.

The display area DA may be an area in which the pixels PXL are disposed, and may be an area in which an image is displayed by the pixels PXL. In an embodiment, the display area DA may be disposed in a center area (for example, a center area of the display panel DP) of the base layer BSL and the display device DD.

The display area DA may have various shapes. For example, the display area DA may have various shapes including a rectangle, a circle, an ellipse, and the like. In an embodiment, the display area DA may have a shape corresponding to a shape of the base layer BSL, but embodiments are not limited thereto.

The non-display area NA may be an area except for the display area DA. In an embodiment, the non-display area NA may be disposed in an edge area of the base layer BSL and the display device DD to surround the display area DA. A portion of the non-display area NA may be a pad area PA in which pads P are disposed.

The pixels PXL may be disposed in the display area DA. For example, the display area DA may include pixel areas in which each pixel PXL is provided and/or disposed. The pixels PXL may be regularly arranged in the display area DA. The pixels PXL may be arranged in the display area DA according to a stripe or PENTILE^{™} arrangement structure or the like, or may be arranged in the display area DA in another structure and/or method.

In an embodiment, at least two types of pixels PXL for emitting light of different colors may be disposed in the display area DA. For example, in the display area DA, first color pixels PXL1, second color pixels PXL2, and third color pixels PXL3 may be arranged. At least one first color pixel PXL1, at least one second color pixel PXL2, and at least one third color pixel PXL3 disposed adjacent to each other may form a pixel group PXG. By individually controlling a luminance of the first, second, and third color pixels PXL1, PXL2, and PXL3 included in each pixel group PXG, a color of light emitted from the pixel group PXG may be variously changed or modified.

In an embodiment, the first color pixel PXL1, the second color pixel PXL2, and the third color pixel PXL3 successively arranged along the first direction DR1 may form each pixel group PXG. For example, the number, type, mutual arrangement structure, and/or the like of the pixels PXL of each pixel group PXG may be variously changed or modified.

In an embodiment, the first color pixel PXL1 may be a red pixel for emitting red light, and the second color pixel PXL2 may be a green pixel for emitting green light. For example, the third color pixel PXL3 may be a blue pixel for emitting blue light. For example, the color of the light emitted from the pixels PXL of each pixel group PXG may be variously changed or modified.

In an embodiment, each pixel PXL may include at least one light emitting element LD. For example, the pixel PXL may include the light emitting element LD as illustrated in FIGS. 1 to 12. For example, the pixel PXL may include at least one light emitting element LD including the light emitting layer EML disposed in the groove GRV and manufactured in a rod shape of a size belonging to an about nanometer to micrometer range. The number, type, structure, size, and/or the like of the light emitting elements LD, as a light source of the pixel PXL, may be variously changed or modified.

In an embodiment, the first color pixel PXL1, the second color pixel PXL2, and the third color pixel PXL3 may include the light emitting elements LD of a first color, a second color, and a third color as light sources, respectively. Accordingly, the first color pixel PXL1, the second color pixel PXL2, and the third color pixel PXL3 may emit light of the first color, light of the second color, and light of the third color, respectively.

In another example, the first color pixel PXL1, the second color pixel PXL2, and the third color pixel PXL3 may include the light emitting elements LD that emit light of the same color, and a light conversion layer including wavelength conversion particles (for example, particles converting a color and/or a wavelength of light such as a quantum dot (QD)) may be disposed in an emission area of the first color pixel PXL1, the second color pixel PXL2, and/or the third color pixel PXL3. Accordingly, the first color pixel PXL1, the second color pixel PXL2, and the third color pixel PXL3 may emit light of the first color, light of the second color, and light of the third color, respectively.

For example, the first color pixel PXL1, the second color pixel PXL2, and the third color pixel PXL3 may include blue light emitting elements, a light conversion layer including wavelength conversion particles of the first color (for example, a red quantum dot) may be disposed in the emission area of the first color pixel PXL1, and a light conversion layer including wavelength conversion particles of the second color (for example, a green quantum dot) may be disposed in the emission area of the second color pixel PXL2. Accordingly, the first color pixel PXL1 may emit the light of the first color (for example, red light), and the second color pixel PXL2 may emit the light of the second color (for example, green light).

The pixels PXL may have a structure according to at least one of the embodiments to be described below. For example, the pixels PXL may have a structure to which any one of the embodiments to be described below is applied, or a structure to which at least two embodiments are applied in combination.

In an embodiment, the pixel PXL may be formed as an active pixel, but embodiments are not limited thereto. For example, in another example, the pixel PXL may be formed as a passive pixel.

Lines and/or a built-in circuit unit connected to the pixels PXL of the display area DA may be disposed in the non-display area NA. For example, a portion of the non-display area NA may be set as the pad area PA, and the pads P may be disposed in the pad area PA. The pads P may include signal pads and/or power pads to which various driving signals and/or power (for example, power voltages) for driving the pixels PXL are applied.

In an embodiment, the non-display area NA may have a narrow width. For example, the non-display area NA may have a width of about 100 micrometers or less. Accordingly, the display device DD may be implemented as a bezel-less display device.

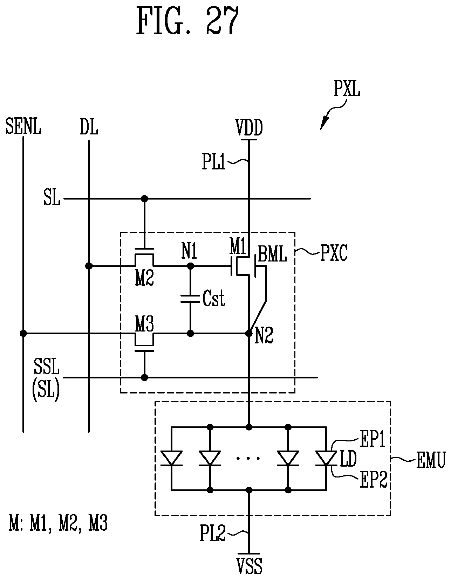

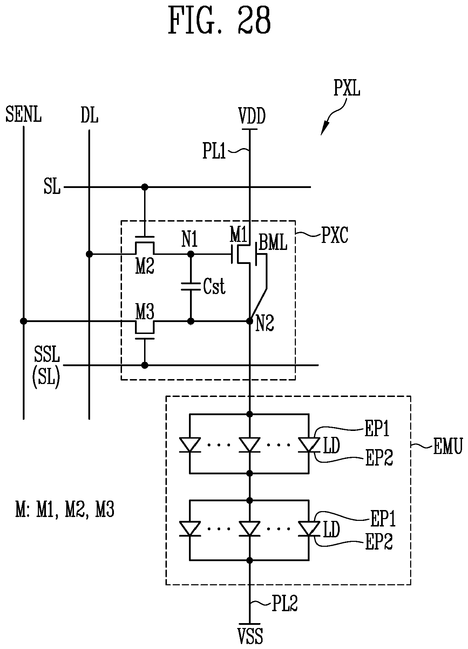

FIGS. 27 and 28 are schematic diagrams of equivalent circuits of pixels PXL, respectively, according to an embodiment. For example, FIGS. 27 and 28 illustrate the pixels PXL including the light emitting units EMU of different structures.

According to an embodiment, each pixel PXL of FIGS. 27 and 28 may be any one of the pixels PXL disposed in the display area DA of FIG. 26. The pixels PXL may have structures substantially identical to or similar to each other.

Referring to FIGS. 27 and 28, the pixel PXL may be connected to a scan line SL (also referred to as a "first scan line"), a data line DL, a first power line PL1, and a second power line PL2. For example, the pixel PXL may be further connected to at least another power line and/or signal line. For example, the pixel PXL may be further connected to a sensing line SENL (also referred to as an "initialization power line") and/or a control line SSL (also referred to as a "second scan line").

The pixel PXL may include a light emitting unit EMU for generating light of a luminance corresponding to each data signal. For example, the pixel PXL may further include a pixel circuit PXC for driving the light emitting unit EMU.

The pixel circuit PXC may be connected to the scan line SL and the data line DL, and may be connected between the first power line PL1 and the light emitting unit EMU. For example, the pixel circuit PXC may be connected (e.g., electrically connected) to the scan line SL to which a first scan signal is supplied, the data line DL to which a data signal is supplied, the first power line PL1 to which a voltage of first power VDD is applied, and the light emitting unit EMU.

The pixel circuit PXC may be selectively further connected to the control line SSL to which a second scan signal is supplied, and the sensing line SENL connected to reference power (or initialization power) or a sensing circuit in response to a display period or a sensing period. In an embodiment, the second scan signal may be a signal identical to or different from the first scan signal. In the case that the second scan signal is the signal identical to the first scan signal, the control line SSL may be integral with the scan line SL.

The pixel circuit PXC may include at least one transistor M and a capacitor Cst. For example, the pixel circuit PXC may include a first transistor M1, a second transistor M2, a third transistor M3, and the capacitor Cst.

The first transistor M1 may be connected between the first power line PL1 and a second node N2. The second node N2 may be a node to which the pixel circuit PXC and the light emitting unit EMU are connected. For example, the second node N2 may be a node at which an electrode (for example, a source electrode) of the first transistor M1 and the light emitting unit EMU are connected (e.g., electrically connected) to each other. A gate electrode of the first transistor M1 may be connected to a first node N1. The first transistor M1 may control a driving current supplied to the light emitting unit EMU in response to a voltage of the first node N1. For example, the first transistor M1 may be a driving transistor of the pixel PXL.

In an embodiment, the first transistor M1 may further include a bottom metal layer BML (also referred to as a "back gate electrode" or a "second gate electrode"). In an embodiment, the bottom metal layer BML may be connected to an electrode (for example, the source electrode) of the first transistor M1.

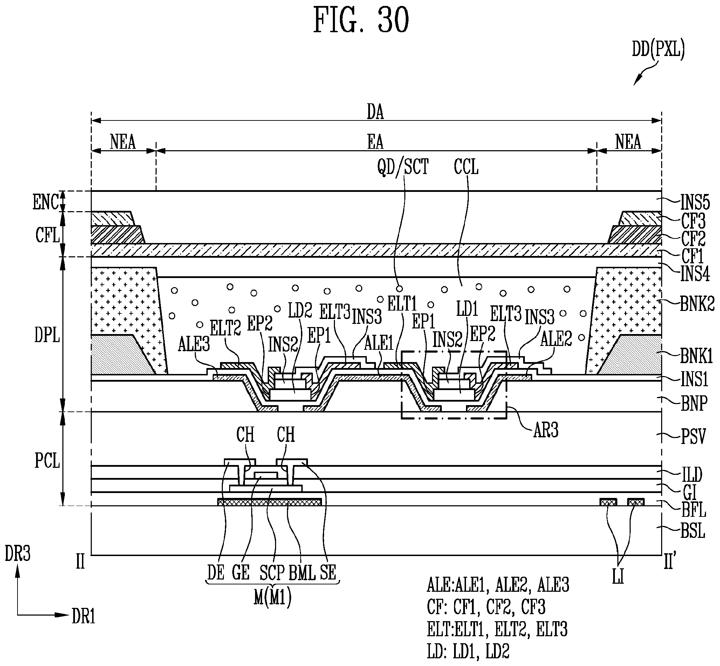

In an embodiment in which the first transistor M1 includes the bottom metal layer BML, a back-biasing technique (or a sync technique) for moving a threshold voltage of the first transistor M1 in a negative or positive direction by applying a back-biasing voltage to the bottom metal layer BML of the first transistor M1 may be applied. In the case that the bottom metal layer BML is disposed under a semiconductor pattern layer (for example, a semiconductor pattern layer SCP of FIG. 30) forming a channel of the first transistor M1, light incident to the semiconductor pattern layer may be blocked, thereby stabilizing an operation characteristic of the first transistor M1.

The second transistor M2 may be connected between the data line DL and the first node N1. For example, a gate electrode of the second transistor M2 may be connected to the scan line SL. The second transistor M2 may be turned on in the case that a first scan signal of a gate-on voltage (for example, a logic high voltage or a high level voltage) is supplied from the scan line SL, to connect the data line DL and the first node N1.

A data signal of a corresponding frame (or each frame) may be supplied to the data line DL for each frame period, and the data signal may be transmitted to the first node N1 through the second transistor M2 during a period in which the first scan signal of the gate-on voltage is supplied. For example, the second transistor M2 may be a switching transistor for transmitting each data signal to an inside of the pixel PXL.

A first electrode of the capacitor Cst may be connected to the first node N1, and a second electrode of the capacitor Cst may be connected to the second node N2. The capacitor Cst may be charged with a voltage corresponding to the data signal supplied to the first node N1 during each frame period.

The third transistor M3 may be connected between the second node N2 and the sensing line SENL. For example, a gate electrode of the third transistor M3 may be connected to the control line SSL (or the scan line SL). The third transistor M3 may be turned on in the case that a second scan signal (or a first scan signal) of a gate-on voltage (for example, a logic high voltage or a high level voltage) is supplied from the control line SSL, to transmit a reference voltage (or an initialization voltage) supplied to the sensing line SENL to the second node N2 or transmit a voltage of the second node N2 to the sensing line SENL. In an embodiment, the voltage of the second node N2 may be transmitted to a sensing circuit through the sensing line SENL, and may be provided to the driving circuit (for example, the timing controller) to be used in compensation or the like of a characteristic deviation of the pixels PXL.

In FIGS. 27 and 28, all of the transistors M included in the pixel circuit PXC are N-type transistors, but embodiments are not limited thereto. For example, at least one of the first, second, and third transistors M1, M2, and M3 may be changed or modified to a P-type transistor. A structure and a driving method of the pixel PXL may be variously changed or modified.

The light emitting unit EMU may include at least one light emitting element LD. In an embodiment, the light emitting unit EMU may include a single light emitting element LD connected in a forward-bias direction between the first power VDD and the second power VSS. In another example, the light emitting unit EMU may include light emitting elements LD connected in the forward-bias direction between the first power VDD and the second power VSS. At least one light emitting element LD connected in the forward-bias direction between the first power VDD and the second power VSS may form an effective light source of the pixel PXL.

In an embodiment, the light emitting unit EMU may include light emitting elements LD connected in parallel between the pixel circuit PXC and the second power line PL2 as illustrated in FIG. 27. The first ends EP1 of the light emitting elements LD may be connected (e.g., electrically connected) to the pixel circuit PXC and may be connected (e.g., electrically connected) to the first power line PL1 through the pixel circuit PXC. The second ends EP2 of the light emitting elements LD may be connected (e.g., electrically connected) to the second power line PL2. A voltage of the second power VSS may be applied to the second power line PL2.

The number, type, and/or structure of the light emitting elements LD forming the effective light source of the pixel PXL may be changed or modified. For example, an arrangement and/or a connection structure of the light emitting elements LD may also be changed or modified.

In an embodiment, the light emitting unit EMU may include light emitting elements LD connected in series and/or parallel between the pixel circuit PXC and the second power line PL2 as illustrated in FIG. 28. For example, the light emitting elements LD may be arranged and/or connected to at least two series stages between the pixel circuit PXC and the second power line PL2, and each series stage may include at least one light emitting element LD connected in the forward-bias direction between the first power VDD and the second power VSS.

The first power VDD and the second power VSS may have different potentials. For example, the first power VDD may be high potential power, and the second power VSS may be low potential power. A potential difference between the first power VDD and the second power VSS may be equal to or greater than a threshold voltage of the light emitting elements LD.

The light emitting elements LD may emit light with a luminance corresponding to a driving current supplied through the pixel circuit PXC. During each frame period, the pixel circuit PXC may supply the driving current corresponding to the data signal to the light emitting unit EMU. The driving current supplied to the light emitting unit EMU may flow through the light emitting elements LD to emit light by the light emitting elements LD. Accordingly, the light emitting unit EMU may emit light with a luminance corresponding to the driving current.

FIGS. 27 and 28 show the light emitting elements LD (e.g., effective light sources) connected in the forward-bias direction between the first power VDD and the second power VSS, but embodiments are not limited thereto. For example, the light emitting unit EMU may further include at least one ineffective light source in addition to the light emitting elements LD as each effective light source. For example, the light emitting unit EMU may further include at least one ineffective light emitting element arranged in a reverse-bias direction between the first power VDD and the second power VSS or having at least one electrical floating end.

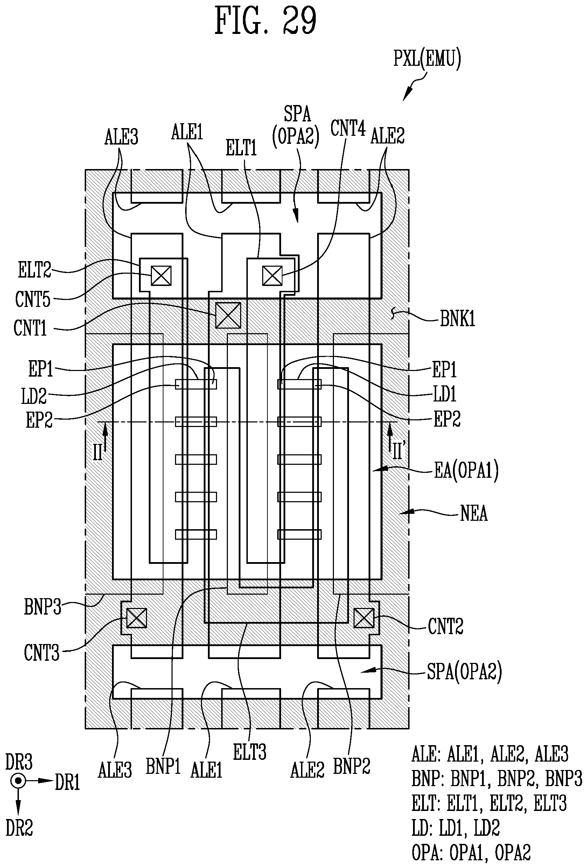

FIG. 29 is a schematic plan view illustrating a pixel PXL according to an embodiment. For example, FIG. 29 illustrates a structure of the pixel PXL based on the light emitting unit EMU, and illustrates an embodiment of the light emitting unit EMU including the light emitting elements LD connected to each other in series and/or parallel as illustrated in FIG. 29.

Referring to FIGS. 1 to 29, the pixel PXL may include an emission area EA in which at least one light emitting element LD is disposed. In an embodiment, the emission area EA may include at least two light emitting elements LD and electrodes connected (e.g., electrically connected) to the light emitting elements LD. In an embodiment, the electrodes may include alignment electrodes ALE and pixel electrodes ELT (also referred to as "contact electrodes"). For example, the pixel PXL may further include bank pattern layers BNP disposed under the alignment electrodes ALE.

The alignment electrodes ALE may have various shapes and may be spaced apart from each other. In an embodiment, the alignment electrodes ALE may be spaced apart from each other along the first direction DR1, and each of the alignment electrodes ALE may have a shape (for example, a bar shape) extending along the second direction DR2.

The shape, size, number, position, and/or mutual disposition structure of the alignment electrodes ALE may be variously changed or modified. For example, the alignment electrodes ALE may have shapes and/or sizes similar to or identical to each other, or may have different shapes and sizes.

The alignment electrodes ALE may include at least two electrodes spaced apart from each other. For example, the alignment electrodes ALE may include a first alignment electrode ALE1 and a second alignment electrode ALE2, and may selectively further include a third alignment electrode ALE3.

In an embodiment, the first alignment electrode ALE1 may be positioned at a center of the emission area EA, and the second alignment electrode ALE2 and the third alignment electrode ALE3 may be disposed on both sides (e.g., opposite sides) of the first alignment electrode ALE1. For example, the second alignment electrode ALE2 may be disposed on a right side of the first alignment electrode ALE1, and the third alignment electrode ALE3 may be disposed on a left side of the first alignment electrode ALE1 (e.g., in the first direction DR1).

The alignment electrodes ALE (or alignment lines before being separated into the alignment electrodes ALE of each of the pixels PXL) may receive alignment signals required for alignment of the light emitting elements LD in an alignment step of the light emitting elements LD. Accordingly, an electric field may be formed between the alignment electrodes ALE, and thus the light emitting elements LD may be aligned and/or arranged between the alignment electrodes ALE. Here, a case where the light emitting elements LD are aligned and/or arranged between the alignment electrodes ALE may mean that at least a portion of each of the light emitting elements LD is disposed between the alignment electrodes ALE.

For example, the first alignment electrode ALE1, the second alignment electrode ALE2, and the third alignment electrode ALE3 (or a first alignment line of a state in which the first alignment electrodes ALE1 of the pixels PXL are connected, a second alignment line of a state in which the second alignment electrodes ALE2 of the pixels PXL are connected, and a third alignment line of a state in which the third alignment electrodes ALE3 of the pixels PXL are connected) may receive a first alignment signal, a second alignment signal, and a third alignment signal, respectively, in the alignment step of the light emitting elements LD. The first alignment signal and the second alignment signal may have different waveforms, potentials, and/or phases. Accordingly, an electric field may be formed between the first alignment electrode ALE1 and the second alignment electrode ALE2, and thus the light emitting elements LD (for example, the first light emitting elements LD1) may be aligned between the first alignment electrode ALE1 and the second alignment electrode ALE2. The first alignment signal and the third alignment signal may have different waveforms, potentials, and/or phases. Accordingly, an electric field may be formed between the first alignment electrode ALE1 and the third alignment electrode ALE3, and thus the light emitting elements LD (for example, the second light emitting elements LD2) may be aligned between the first alignment electrode ALE1 and the third alignment electrode ALE3. The third alignment signal may be a signal identical to or different from the second alignment signal.

The alignment electrodes ALE may be disposed in the emission area EA of each pixel PXL. In an embodiment, the alignment electrodes ALE may extend to a separation area SPA through a non-emission area NEA around (or surrounding) the emission area EA. The separation area SPA may be an area where each alignment line (for example, the first alignment line, the second alignment line, or the third alignment line) is separated into the alignment electrodes ALE of the pixels PXL (for example, the first alignment electrodes ALE1, the second alignment electrodes ALE2, or the third alignment electrodes ALE3 of the pixels PXL) after the alignment of the light emitting elements LD is completed, and may be disposed on at least one side of each emission area EA.

For example, each pixel PXL may include at least one separation area SPA (for example, two separation areas SPA disposed above and below each emission area EA) disposed around the emission area EA. For example, an end of at least one electrode of the light emitting unit EMU (for example, ends of the alignment electrodes ALE) may be disposed in each separation area SPA.

In an embodiment, each alignment electrode ALE may have a separated pattern for each pixel PXL. For example, each of the first, second, and third alignment electrodes ALE1, ALE2, and ALE3 of each of the pixels PXL may have an individually separated pattern.

However, embodiments are not limited thereto. For example, in a structure in which the second pixel electrodes ELT2 of the pixels PXL are commonly connected to the second power line PL2, the alignment electrodes ALE (for example, the third alignment electrodes ALE3 of the pixels PXL) connected to the second pixel electrodes ELT2 may not be disconnected between the pixels PXL adjacent to each other along the first direction DR1 and/or the second direction DR2 and may be integral with each other.

In an embodiment, the first alignment electrode ALE1 may be connected (e.g., electrically connected) to the pixel circuit PXC (for example, the pixel circuit PXC of the corresponding pixel PXL) and/or the first power line PL1 positioned in a circuit layer (for example, the circuit layer PCL) through a first contact portion CNT1. For example, the first alignment signal may be supplied to the first alignment electrode ALE1 (or the first alignment line) through at least one line (for example, the first power line PL1) positioned in the circuit layer.

The first contact portion CNT1 may include at least one contact hole and/or via hole. In an embodiment, the first contact portion CNT1 may be positioned in the non-emission area NEA positioned around each emission area EA, but a position of the first contact portion CNT1 may be changed or modified. For example, the first contact portion CNT1 may be disposed in each emission area EA or separation area SPA.

In an embodiment, the second alignment electrode ALE2 may be connected (e.g., electrically connected) to the second power line PL2 positioned in the circuit layer through a second contact portion CNT2. For example, the second alignment signal may be supplied to the second alignment electrode ALE2 (or the second alignment line) through the second power line PL2.

For example, the third alignment electrode ALE3 may be connected (e.g., electrically connected) to the second power line PL2 positioned in the circuit layer through a third contact portion CNT3. For example, the second alignment signal may be supplied to the third alignment electrode ALE3 (or the third alignment line) through the second power line PL2.

Each of the second contact portion CNT2 and the third contact portion CNT3 may include at least one contact hole and/or via hole. In an embodiment, the second contact portion CNT2 and the third contact portion CNT3 may be positioned in the non-emission area NEA positioned around each emission area EA, but positions of the second contact portion CNT2 and the third contact portion CNT3 may be changed or modified. For example, the second contact portion CNT2 and the third contact portion CNT3 may be disposed in each emission area EA or separation area SPA.

At least one first light emitting element LD1 may be disposed between the first alignment electrode ALE1 and the second alignment electrode ALE2. For example, first light emitting elements LD1 may be arranged between the first alignment electrode ALE1 and the second alignment electrode ALE2.

Each first light emitting element LD1 may or may not overlap the first alignment electrode ALE1 and/or the second alignment electrode ALE2. The first end EP1 of the first light emitting element LD1 may be disposed adjacent to the first alignment electrode ALE1, and the second end EP2 of the first light emitting element LD1 may be disposed adjacent to the second alignment electrode ALE2.

The first end EP1 of the first light emitting element LD1 may be connected (e.g., electrically connected) to the first pixel electrode ELT1. In an embodiment, the first end EP1 of the first light emitting element LD1 may be connected (e.g., electrically connected) to the first alignment electrode ALE1 through the first pixel electrode ELT1, and may be connected (e.g., electrically connected) to the pixel circuit PXC and/or the first power line PL1 through the first alignment electrode ALE1.

The second end EP2 of the first light emitting element LD1 may be connected (e.g., electrically connected) to the third pixel electrode ELT3 and/or the second pixel electrode ELT2. In an embodiment, the second end EP2 of the first light emitting element LD1 may be connected (e.g., electrically connected) to the third pixel electrode ELT3. For example, the second end EP2 of the first light emitting element LD1 may be connected (e.g., electrically connected) to the second power line PL2 via the third pixel electrode ELT3, at least one second light emitting element LD2, the second pixel electrode ELT2, and the third alignment electrode ALE3 sequentially.

At least one second light emitting element LD2 may be disposed between the first alignment electrode ALE1 and the third alignment electrode ALE3. For example, second light emitting elements LD2 may be arranged between the first alignment electrode ALE1 and the third alignment electrode ALE3.

Each second light emitting element LD2 may or may not overlap the first alignment electrode ALE1 and/or the third alignment electrode ALE3. The first end EP1 of the second light emitting element LD2 may be disposed adjacent to the first alignment electrode ALE1, and the second end EP2 of the second light emitting element LD2 may be disposed adjacent to the third alignment electrode ALE3.

The first end EP1 of the second light emitting element LD2 may be connected (e.g., electrically connected) to the third pixel electrode ELT3. The second end EP2 of the second light emitting element LD2 may be connected (e.g., electrically connected) to the second pixel electrode ELT2. In an embodiment, the second end EP2 of the second light emitting element LD2 may be connected (e.g., electrically connected) to the third alignment electrode ALE3 through the second pixel electrode ELT2, and may be connected (e.g., electrically connected) to the second power line PL2 through the third alignment electrode ALE3.

In an embodiment, each light emitting element LD may be an inorganic light emitting element of an ultra-small size (for example, having a small size in a range of nanometer to micrometer) using a material of an inorganic crystalline structure. For example, each light emitting element LD may be an inorganic light emitting element of an ultra-small size manufactured in a rod shape as illustrated in FIGS. 1 and 12 by growing a nitride-based semiconductor or a phosphide-based semiconductor. However, the type, size, shape, structure, number, and/or the like of the light emitting elements LD of each light emitting unit EMU may be changed or modified.

The light emitting elements LD may be dispersed in a solution and prepared in a form of a light emitting element mixture liquid (or a light emitting element ink), and may be supplied to each emission area EA by an inkjet method, a slit coating method, or the like. In the case that the alignment signals are applied to the alignment electrodes ALE (or the alignment lines) of the pixels PXL simultaneously or after supply of the light emitting elements LD, an electric field may be formed between the alignment electrodes ALE, and thus the light emitting elements LD may be aligned. After the alignment of the light emitting elements LD is completed, a solvent may be removed through a drying process or the like.

The first pixel electrode ELT1 may be disposed on the first ends EP1 of the first light emitting elements LD1, and may be connected (e.g., electrically connected) to the first ends EP1 of the first light emitting elements LD1. For example, the first pixel electrode ELT1 may be disposed (e.g., directly disposed) on the first ends EP1 of the first light emitting elements LD1 to be in contact with the first ends EP1 of the first light emitting elements LD1.

In an embodiment, the first pixel electrode ELT1 may overlap the first alignment electrode ALE1 and may be connected (e.g., electrically connected) to the first alignment electrode ALE1 through a fourth contact portion CNT4. For example, the first pixel electrode ELT1 may be connected (e.g., electrically connected) to the pixel circuit PXC and/or the first power line PL1 through the first alignment electrode ALE1. In another example, the first pixel electrode ELT1 may be connected (e.g., electrically connected) to the pixel circuit PXC and/or the first power line PL1 without passing through the first alignment electrode ALE1.

The third pixel electrode ELT3 may be disposed on the second ends EP2 of the first light emitting elements LD1 and the first ends EP1 of the second light emitting elements LD2, and may be connected (e.g., electrically connected) to the second ends EP2 of the first light emitting elements LD1 and the first ends EP1 of the second light emitting elements LD2. For example, the third pixel electrode ELT3 may be disposed (e.g., directly disposed) on the second ends EP2 of the first light emitting elements LD1 and the first ends EP1 of the second light emitting elements LD2 to be in contact with the second ends EP2 of the first light emitting elements LD1 and the first ends EP1 of the second light emitting elements LD2. The third pixel electrode ELT3 may be an intermediate electrode for connecting (e.g., electrically connecting) the first light emitting elements LD1 and the second light emitting elements LD2. In an embodiment, the third pixel electrode ELT3 may overlap a portion of each of the first and second alignment electrodes ALE1 and ALE2, but embodiments are not limited thereto.

The second pixel electrode ELT2 may be disposed on the second ends EP2 of the second light emitting elements LD2 and may be connected (e.g., electrically connected) to the second ends EP2 of the second light emitting elements LD2. For example, the second pixel electrode ELT2 may be disposed (e.g., directly disposed) on the second ends EP2 of the second light emitting elements LD2 to be in contact with the second ends EP2 of the second light emitting elements LD2.

In an embodiment, the second pixel electrode ELT2 may overlap the third alignment electrode ALE3, and may be connected (e.g., electrically connected) to the third alignment electrode ALE3 through a fifth contact portion CNT5. For example, the second pixel electrode ELT2 may be connected (e.g., electrically connected) to the second power line PL2 through the third alignment electrode ALE3. In another example, the second pixel electrode ELT2 may be connected (e.g., electrically connected) to the second power line PL2 without passing through the third alignment electrode ALE3.

The pixel electrodes ELT (for example, the first pixel electrode ELT1, the second pixel electrode ELT2, and the third pixel electrode ELT3) may be formed in each emission area EA. In an embodiment, at least one pixel electrode ELT may extend from each emission area EA to the non-emission area NEA and/or the separation area SPA. For example, the first pixel electrode ELT1 and the second pixel electrode ELT2 may extend from each emission area EA to the non-emission area NEA and the separation area SPA, and may be connected (e.g., electrically connected) to the first alignment electrode ALE1 and the third alignment electrode ALE3 in the separation area SPA, respectively. The third pixel electrode ELT3 may be formed only in each emission area EA, or a portion of the third pixel electrode ELT3 may be positioned in the non-emission area NEA. The position, size, shape, mutual disposition structure of the pixel electrodes ELT, the positions of the fourth and fifth contact portions CNT4 and CNT5, and/or the like may be variously changed or modified.

The bank pattern layers BNP (also referred to as "pattern layers" or "wall pattern layers") may be disposed under the alignment electrodes ALE to overlap a portion of the alignment electrodes ALE. For example, the bank pattern layers BNP may include a first bank pattern layer BNP1, a second bank pattern layer BNP2, and a third bank pattern layer BNP3 overlapping a portion the first alignment electrode ALE1, the second alignment electrode ALE2, and the third alignment electrode ALE3, respectively. In an embodiment, at least one bank pattern layer BNP may extend to the non-emission area NEA around the emission area EA, but embodiments are not limited thereto.

A portion of the alignment electrodes ALE may protrude in an upper direction (for example, the third direction DR3) of the pixel PXL by the bank pattern layers BNP. Accordingly, an area in which the light emitting elements LD are aligned may be readily controlled, and light emitted at a low angle toward the bank pattern layers BNP among the light emitted from the light emitting elements LD may be reflected in the upper direction of the pixel PXL to increase light efficiency of the pixel PXL.

In an embodiment, at least two adjacent pixels PXL may share at least one bank pattern layer BNP. For example, the second bank pattern layer BNP2 may be integral with the third bank pattern layer BNP3 of the pixel PXL adjacent in the first direction DR1 (for example, an adjacent pixel of a right side). For example, the third bank pattern layer BNP3 may be integral with the second bank pattern layer BNP2 of another pixel adjacent in the first direction DR1 (for example, an adjacent pixel of a left side). The position, structure, number, shape, and/or the like of the bank pattern layers BNP may be variously changed or modified.

The non-emission area NEA may be disposed around each emission area EA and/or each separation area SPA. A first bank BNK1 may be disposed in the non-emission area NEA.

The first bank BNK1 may include a first opening OPA1 corresponding to each emission area EA, and may surround the emission area EA. For example, the first bank BNK1 may include second openings OPA2 corresponding to the separation areas SPA and surround the separation areas SPA. For example, the first bank BNK1 may include openings OPA corresponding to each emission area EA and each separation area SPA.

The first bank BNK1 may include at least one light blocking and/or reflective material. For example, the first bank BNK1 may include at least one black matrix material, color filter material of a specific color, and/or the like. Accordingly, light leakage between adjacent pixels PXL may be prevented.

The first bank BNK1 may define each emission area EA to which the light emitting elements LD are to be supplied in a step of supplying the light emitting elements LD to each pixel PXL. For example, as the emission areas EA of the pixels PXL are separated and partitioned by the first bank BNK1, a desired type and/or amount of a light emitting element mixture liquid may be supplied.

In an embodiment, the first bank BNK1 may include a hydrophobic surface. For example, the first bank BNK1 may be formed to have the hydrophobic surface by forming the first bank BNK1 itself in a hydrophobic pattern using a hydrophobic material or by forming a hydrophobic film formed of a hydrophobic material on the first bank BNK1. For example, the first bank BNK1 may be formed of a hydrophobic organic insulating material having a large contact angle, such as polyacrylate, and thus the first bank BNK1 may be formed in a hydrophobic pattern. Accordingly, the light emitting element mixture liquid may stably flow into the emission area EA.

FIG. 30 is a schematic cross-sectional view illustrating a display device DD according to an embodiment. For example, FIG. 30 illustrates an embodiment of a cross section of the display device DD based on a cross section of the pixel PXL, taken along line II-II' of FIG. 29.

Referring to FIGS. 1 to 30, the display device DD may include a base layer BSL, the circuit layer PCL, and a display layer DPL. The circuit layer PCL and the display layer DPL may overlap each other on the base layer BSL. For example, the circuit layer PCL and the display layer DPL may be sequentially disposed on a surface of the base layer BSL.

For example, the display device DD may further include a color filter layer CFL and/or an encapsulation layer ENC (or a protective layer) disposed on the display layer DPL. In an embodiment, the color filter layer CFL and/or the encapsulation layer ENC may be formed (e.g., directly formed) on a surface of the base layer BSL on which the circuit layer PCL and the display layer DPL are formed, but embodiments are not limited thereto.

The base layer BSL may be a substrate or a film of a rigid or flexible material. In an embodiment, the base layer BSL may include at least one transparent or opaque insulating material, and may have a structure of a single layer or multiple layers.

The circuit layer PCL may be disposed on a surface of the base layer BSL. The circuit layer PCL may include circuit elements of the pixel circuit PXC of each pixel PXL. For example, circuit elements (for example, the transistors M and the capacitor Cst of each pixel circuit PXC) may be formed in each pixel area of the circuit layer PCL.

In FIG. 30, as an example of the circuit elements that may be disposed in the circuit layer PCL, any one transistor M (for example, the first transistor M1 including the bottom metal layer BML) included in each pixel circuit PXC is illustrated.

For example, the circuit layer PCL may include various signal lines and power lines connected to the pixels PXL. For example, the circuit layer PCL may include scan lines SL, data lines DL, sensing lines SENL, and first and second power lines PL1 and PL2 connected to the pixels PXL. In FIG. 30, lines LI and the bottom metal layer BML, as examples of lines that may be disposed in the circuit layer PCL (for example, a first conductive layer), may be respectively formed of the same material, and may be disposed on the same layer (e.g., the base layer BSL). Each line LI may be any one of the signal lines and the power lines connected to the pixels PXL. In an embodiment, at least one signal line and/or power line may be disposed in another layer of the circuit layer PCL.

For example, the circuit layer PCL may include insulating layers. For example, the circuit layer PCL may include a buffer layer BFL, a gate insulating layer GI, an interlayer insulating layer ILD, and/or a passivation layer PSV sequentially disposed on a surface of the base layer BSL.

The circuit layer PCL may include a first conductive layer disposed on the base layer BSL and including the bottom metal layer BML of the first transistor M1. For example, the first conductive layer may be disposed between the base layer BSL and the buffer layer BFL and include the bottom metal layer BML of the first transistor M1 included in each pixel circuit PXC. The bottom metal layer BML of the first transistor M1 may overlap a gate electrode GE and the semiconductor pattern layer SCP of the first transistor M1.

For example, the first conductive layer may further include at least one line LI. For example, the first conductive layer may include at least some lines LI among lines extending in the second direction DR2 in the display area DA. For example, the first conductive layer may include the sensing lines SENL and the data lines DL connected to the pixels PXL, the first power line PL1 (or a first sub power line of the first power line PL1 of a mesh shape extending in the second direction DR2), and/or the second power line PL2 (or a second sub power line of the second power line PL2 of a mesh shape extending in the second direction DR2).

The buffer layer BFL may be disposed on a surface of the base layer BSL including the first conductive layer. The buffer layer BFL may prevent an impurity from diffusing into each circuit element.

A semiconductor layer may be disposed on the buffer layer BFL. The semiconductor layer may include the semiconductor pattern layer SCP of each transistor M. The semiconductor pattern layer SCP may include a channel area overlapping the gate electrode GE of the corresponding transistor M, and first and second conductive areas (for example, source and drain areas) disposed on both sides (e.g., opposite sides) of the channel area. The semiconductor pattern layer SCP may be a semiconductor pattern layer formed of polysilicon, amorphous silicon, an oxide semiconductor, or the like.

The gate insulating layer GI may be disposed on the semiconductor pattern layer SCP. For example, a second conductive layer may be disposed on the gate insulating layer GI.

The second conductive layer may include the gate electrode GE of each transistor M. For example, the second conductive layer may further include an electrode of the capacitor Cst, a bridge pattern layer, and/or the like disposed in the pixel circuit PXC. For example, in the case that at least one power line and/or signal line disposed in the display area DA is formed as multiple layers, the second conductive layer may further include at least one conductive pattern layer of the at least one power line and/or signal line.

The interlayer insulating layer ILD may be disposed on the second conductive layer. For example, a third conductive layer may be disposed on the interlayer insulating layer ILD.

The third conductive layer may include a source electrode SE and a drain electrode DE of each transistor M. The source electrode SE may be connected to an area (for example, the source area) of the semiconductor pattern layer SCP included in the corresponding transistor M through at least one contact hole CH, and the drain electrode DE may be connected to another area (for example, the drain area) of the semiconductor pattern layer SCP included in the corresponding transistor M through at least another contact hole CH. For example, the third conductive layer may further include another electrode of the capacitor Cst, lines (e.g., predetermined lines), a bridge pattern layer, and/or the like disposed in the pixel circuit PXC. For example, the third conductive layer may include at least some lines among lines extending in the first direction DR1 in the display area DA. For example, the third conductive layer may include the scan lines SL, the control lines SSL, the first power line PL1 (or a first sub power line of the first power line PL1 of the mesh shape extending in the first direction DR1), and/or the second power line PL2 (or a second sub power line of the second power line PL2 of the mesh shape extending in the first direction DR1) connected to the pixels PXL. For example, in the case that at least one power line and/or signal line disposed in the display area DA is formed as multiple layers, the third conductive layer may further include at least one conductive pattern layer of the at least one power line and/or signal line.

Each conductive pattern layer, electrode and/or line of the first to third conductive layers may have conductivity by including at least one conductive material, and a material thereof is not limited thereto. For example, each conductive pattern layer, electrode and/or line of the first to third conductive layers may include one or more metals selected from molybdenum (Mo), aluminium (Al), platinum (Pt), palladium (Pd), silver (Ag), magnesium (Mg), gold (Au), nickel (Ni), neodymium (Nd), iridium (Ir), chromium (Cr), titanium (Ti), tantalum (Ta), tungsten (W), and copper (Cu), and may include various other types of conductive materials.

The passivation layer PSV may be disposed on the third conductive layer. Each of the buffer layer BFL, the gate insulating layer GI, the interlayer insulating layer ILD, and the passivation layer PSV may be formed as a single layer or multiple layers, and may include at least one inorganic insulating material and/or organic insulating material. In an embodiment, each of the buffer layer BFL, the gate insulating layer GI, and the interlayer insulating layer ILD may include various types of inorganic insulating materials including silicon nitride (SiNₓ), silicon oxide (SiOₓ), silicon oxynitride (SiOₓN_{y}), or the like. In an embodiment, the passivation layer PSV may include at least one organic insulating layer including at least one organic insulating material. In an embodiment, the passivation layer PSV may be disposed (e.g., entirely disposed) in at least the display area DA, and may planarize a surface of the circuit layer PCL.

The display layer DPL may be disposed on the passivation layer PSV.

The display layer DPL may include the light emitting unit EMU of each pixel PXL. For example, the display layer DPL may include the alignment electrodes ALE, at least one light emitting element LD, and the pixel electrodes ELT disposed in the emission area EA of each pixel PXL. In an embodiment, each light emitting unit EMU may include light emitting elements LD.

For example, the display layer DPL may further include insulating pattern layers and/or insulating layers sequentially disposed on a surface of the base layer BSL on which the circuit layer PCL is formed. For example, the display layer DPL may include the bank pattern layers BNP, a first insulating layer INS1, the first bank BNK1, a second insulating layer INS2, a third insulating layer INS3, a second bank BNK2, and/or a fourth insulating layer INS4. For example, the display layer DPL may selectively further include a light conversion layer CCL.

The bank pattern layers BNP may be disposed and/or formed on the passivation layer PSV. The bank pattern layers BNP may be disposed under the alignment electrodes ALE to overlap a portion of each of the alignment electrodes ALE.

The alignment electrodes ALE may protrude in an upper direction (for example, the third direction DR3) of the pixel PXL around the light emitting elements LD by the bank pattern layers BNP. The bank pattern layers BNP and the alignment electrodes ALE thereon may form a reflective protrusion pattern layer around the light emitting elements LD. Accordingly, light efficiency of the pixel PXL may be improved.

The bank pattern layers BNP may be insulating pattern layers of a single layer or multiple layers including an inorganic insulating material and/or an organic insulating material. The alignment electrodes ALE may be disposed on the bank pattern layers BNP.

The alignment electrodes ALE may include at least one conductive material. For example, each alignment electrode ALE may include at least one conductive material among at least one metal among various metal materials including silver (Ag), magnesium (Mg), aluminium (Al), platinum (Pt), palladium (Pd), gold (Au), nickel (Ni), neodymium (Nd), iridium (Ir), chromium (Cr), titanium (Ti), molybdenum (Mo), copper (Cu), and the like, an alloy thereof, a conductive oxide such as indium tin oxide (ITO), indium zinc oxide (IZO), indium tin zinc oxide (ITZO), zinc oxide (ZnO), aluminium doped zinc oxide (AZO), gallium doped zinc oxide (GZO), zinc tin oxide (ZTO), gallium tin oxide (GTO), and fluorine doped tin oxide (FTO), and a conductive polymer such as PEDOT, but embodiments are not limited thereto. For example, the alignment electrodes ALE may include another conductive material such as carbon nano tube or graphene. For example, the alignment electrodes ALE may have conductivity by including at least one of various conductive materials. For example, the alignment electrodes ALE may include conductive materials identical to or different from each other.

Each alignment electrode ALE may be formed as a single layer or multiple layers. For example, each alignment electrode ALE may include a reflective electrode layer including a reflective conductive material (for example, metal), and may be formed as an electrode of a single layer or multiple layers.

The first insulating layer INS1 may be disposed on the alignment electrodes ALE. In an embodiment, the first insulating layer INS1 may include a contact hole for connecting at least one of the alignment electrodes ALE to any one pixel electrode ELT. For example, the first insulating layer INS1 may include contact holes for forming the fourth and fifth contact portions CNT4 and CNT5 of FIG. 29.

The first insulating layer INS1 may be formed as a single layer or multiple layers, and may include an inorganic insulating material and/or an organic insulating material. In an embodiment, the first insulating layer INS1 may include at least one type of inorganic insulating material including silicon nitride (SiNₓ), silicon oxide (SiOₓ), or silicon oxynitride (SiOₓN_{y}).

As the alignment electrodes ALE are covered by the first insulating layer INS1, damage to the alignment electrodes ALE in a subsequent process may be prevented. For example, an occurrence of a short circuit defect due to an improper connection between the alignment electrodes ALE and the light emitting elements LD may be prevented.

The first bank BNK1 may be disposed in the display area DA in which the alignment electrodes ALE and the first insulating layer INS1 are formed. The first bank BNK1 may be formed in the non-emission area NEA to surround the emission area EA of each pixel PXL.

The light emitting elements LD may be supplied to each emission area EA surrounded by the first bank BNK1. The light emitting elements LD may be aligned between the alignment electrodes ALE by the alignment signals applied to the alignment electrodes ALE (or the alignment lines before being separated into the alignment electrodes ALE of each pixel PXL). For example, it is assumed that the pixel PXL includes the first alignment electrode ALE1 positioned at a center area and the second and third alignment electrodes ALE2 and ALE3 positioned on both sides (e.g., opposite sides) of the first alignment electrode ALE1, at least one first light emitting element LD1 may be aligned between the first alignment electrode ALE1 and the second alignment electrode ALE2, and at least one second light emitting element LD2 may be aligned between the first alignment electrode ALE1 and the third alignment electrode ALE3.

The second insulating layer INS2 may be disposed on a portion of the light emitting elements LD. For example, the second insulating layer INS2 may be disposed locally on a portion including a center portion of the light emitting elements LD to expose the first and second ends EP1 and EP2 of the light emitting elements LD aligned in the emission area EA of the corresponding pixel PXL. In the case that the second insulating layer INS2 is formed on the light emitting elements LD, the light emitting elements LD may be stably fixed.

The second insulating layer INS2 may be formed as a single layer or multiple layers, and may include at least one inorganic insulating material and/or organic insulating material. For example, the second insulating layer INS2 may include various types of organic and/or inorganic insulating materials including silicon nitride (SiNₓ), silicon oxide (SiOₓ), silicon oxynitride (SiOₓN_{y}), aluminium oxide (AlₓO_{y}), photoresist (PR) material, and the like.

On both ends (e.g., opposite ends), for example, the first and second ends EP1 and EP2 of the light emitting elements LD, which are not covered by the second insulating layer INS2, different pixel electrodes ELT may be disposed and/or formed. For example, the first pixel electrode ELT1 may be disposed on the first end EP1 of the first light emitting element LD1, and a portion of the third pixel electrode ELT3 may be disposed the second end EP2 of the first light emitting element LD1. Another portion of the third pixel electrode ELT3 may be disposed on the first end EP1 of the second light emitting element LD2, and the second pixel electrode ELT2 may be disposed on the second end EP2 of the second light emitting element LD2.

In an embodiment, the first pixel electrode ELT1 may be connected (e.g., electrically connected) to the first alignment electrode ALE1 through at least one contact portion (for example, the fourth contact portion CNT4 of FIG. 29). For example, the second pixel electrode ELT2 may be connected (e.g., electrically connected) to the third alignment electrode ALE3 through at least one contact portion (for example, the fifth contact portion CNT5 of FIG. 29). The third pixel electrode ELT3 may connect (e.g., electrically connect) at least one first light emitting element LD1 and at least one second light emitting element LD2 to each other.

In an embodiment, the first alignment electrode ALE1 of each pixel PXL may be connected (e.g., electrically connected) to the first transistor M1 of the corresponding pixel PXL through at least one contact portion (for example, the first contact portion CNT1 of FIG. 29). For example, the second and third alignment electrodes ALE2 and ALE3 may be connected (e.g., electrically connected) to the second power line PL2 through at least one contact portion (for example, the second contact portion CNT2 and the third contact portion CNT3 of FIG. 29).

The first pixel electrode ELT1 may be disposed on the first alignment electrode ALE1 to overlap a portion of the first alignment electrode ALE1, and the second pixel electrode ELT2 may be disposed on the third alignment electrode ALE3 to overlap a portion of the third alignment electrode ALE3. The third pixel electrode ELT3 may be disposed on the first alignment electrode ALE1 and the second alignment electrode ALE2 to overlap another portion of the first alignment electrode ALE1 and the second alignment electrode ALE2.

In an embodiment, the first pixel electrode ELT1 may be connected (e.g., electrically connected) to the first end EP1 of the first light emitting element LD1, and the second pixel electrode ELT2 may be connected (e.g., electrically connected) to the second end EP2 of the second light emitting element LD2. The third pixel electrode ELT3 may be connected (e.g., electrically connected) to the second end EP2 of the first light emitting element LD1 and the first end EP1 of the second light emitting element LD2.

The first pixel electrode ELT1, the second pixel electrode ELT2, and/or the third pixel electrode ELT3 may be formed as layers identical to or different from each other. In an embodiment, the first and second pixel electrodes ELT1 and ELT2 may be formed in layers identical to each other, and the third pixel electrode ELT3 may be formed as a layer different from that of the first and second pixel electrodes ELT1 and ELT2. For example, the first and second pixel electrodes ELT1 and ELT2 and the third pixel electrode ELT3 may be disposed on layers different from each other with the third insulating layer INS3 interposed therebetween. In another example, all of the first to third pixel electrodes ELT1 to ELT3 may be formed of the same material or the same layer. For example, the pixel PXL may not include the third insulating layer INS3. A mutual position, a formation order, and/or the like of the pixel electrodes ELT may be variously changed or modified.

As illustrated in FIG. 27, in the case that each pixel PXL includes the light emitting unit EMU of a parallel structure or each pixel PXL includes a single light emitting element LD, the pixel PXL may not include the third pixel electrode ELT3. For example, the first pixel electrode ELT1 may be disposed on the first ends EP1 of the light emitting elements LD, and the second pixel electrode ELT2 may be disposed on the second ends EP2 of the light emitting elements LD.

The pixel electrodes ELT may include at least one conductive material. In an embodiment, the pixel electrodes ELT may include a transparent conductive material to transmit the light emitted from the light emitting elements LD through the pixel electrode ELT.

In an embodiment, the display device DD may include the light conversion layer CCL disposed on the light emitting unit EMU of each pixel PXL. For example, the light conversion layer CCL may be disposed in each emission area EA to overlap the light emitting elements LD of each pixel PXL.

For example, the display device DD may further include the second bank BNK2 disposed in the non-emission area NEA to overlap the first bank BNK1. The second bank BNK2 may define (or partition) each emission area EA in which the light conversion layer CCL is formed. In an embodiment, the second bank BNK2 may be integral with the first bank BNK1.

The second bank BNK2 may include a light blocking material including a black matrix material and/or a reflective material. The second bank BNK2 may include a material identical to or different from that of the first bank BNK1.

The light conversion layer CCL may include at least one of wavelength conversion particles (or color conversion particles) for converting a wavelength and/or a color of the light emitted from the light emitting elements LD, and light scattering particles SCT for increasing light output efficiency of the pixel PXL by scattering the light emitted from the light emitting elements LD. For example, each light conversion layer CCL may be disposed on each light emitting unit EMU. Each light conversion layer CCL may include wavelength conversion particles such as at least one type of quantum dot QD (for example, a red quantum dot, a green quantum dot, and/or a blue quantum dot) and/or light scattering particles SCT.

For example, in the case that any one pixel PXL is set as a red (or green) pixel and blue light emitting elements LD are disposed in the light emitting unit EMU of the pixel PXL, the light conversion layer CCL including the red (or green) quantum dot QD for converting blue light into red (or green) light may be disposed on the light emitting unit EMU of the pixel PXL. For example, the light conversion layer CCL may further include the light scattering particles SCT.

The fourth insulating layer INS4 may be disposed on a surface of the base layer BSL, and may cover the light emitting units EMU and/or the light conversion layers CCL of the pixels PXL.

In an embodiment, the fourth insulating layer INS4 may include at least one organic insulating layer. The fourth insulating layer INS4 may be disposed (e.g., entirely disposed) in at least the display area DA, and may substantially planarize a surface of the display layer DPL. For example, the fourth insulating layer INS4 may protect the light emitting units EMU and/or the light conversion layers CCL of the pixels PXL.

The color filter layer CFL may be disposed on the fourth insulating layer INS4.

The color filter layer CFL may include color filters CF corresponding to colors of the pixels PXL. For example, the color filter layer CFL may include a first color filter CF1 disposed in the emission area EA of the first color pixel PXL1, a second color filter CF2 disposed in the emission area EA of the second color pixel PXL2, and a third color filter CF3 disposed in the emission area EA of the third color pixel PXL3. Each color filter CF may be disposed on the fourth insulating layer INS4 to overlap the light emitting unit EMU of the corresponding pixel PXL.

In an embodiment, the first, second, and third color filters CF1, CF2, and CF3 may be disposed to overlap each other in the non-emission area NEA. In another example, the first, second, and third color filters CF1, CF2, and CF3 may be formed to be separated from each other on the emission areas EA of each pixel PXL, and a separate light blocking pattern layer may be disposed between the first, second, and third color filters CF1, CF2, and CF3.

The encapsulation layer ENC may be disposed on the color filter layer CFL. The encapsulation layer ENC may include the fifth insulating layer INS5. In an embodiment, the fifth insulating layer INS5 may include at least one organic insulating layer including at least one organic insulating material, and may be formed as a single layer or multiple layers. The fifth insulating layer INS5 may be formed (e.g., entirely formed) in at least the display area DA to cover the circuit layer PCL, the display layer DPL, and/or the color filter layer CFL, and may planarize a surface of the display device DD.

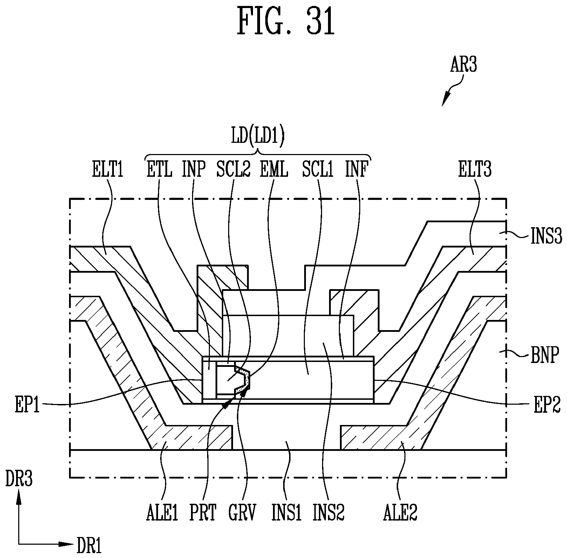

FIG. 31 is a schematic enlarged cross-sectional view of an area of the pixel PXL shown in FIG. 30. For example, FIG. 31 is a schematic enlarged cross-sectional view of an area (for example, a third area AR3) of the pixel PXL based on the first light emitting element LD1. In an embodiment, the light emitting elements LD included in the pixels PXL may be light emitting elements LD of substantially the same or similar type and/or structure. For example, the second light emitting element LD2 may be a light emitting element LD of the same type and/or structure as the first light emitting element LD1.

FIG. 31 shows an embodiment in which the pixel PXL of FIG. 30 includes the light emitting element LD according to the embodiments of FIGS. 1 to 3, but embodiments are not limited thereto. For example, the pixel PXL may include the light emitting element LD according to any one of the embodiments of FIGS. 4 to 12, or the light emitting element LD having a shape and/or a structure to which at least two of the embodiments of FIGS. 2 to 12 are applied in combination.

Referring to FIGS. 1 to 31, each light emitting element LD of the light emitting unit EMU of the pixel PXL may include the first semiconductor layer SCL1, the light emitting layer EML, and the second semiconductor layer SCL2 sequentially disposed from the second end EP2 to the first end EP1, and the insulating pattern layer INP surrounding the second semiconductor layer SCL2. For example, each light emitting element LD may selectively further include the electrode layer ETL and/or the insulating film INF.

The first semiconductor layer SCL1 includes the groove GRV and the protrusion PRT. The protrusion PRT surrounds the groove GRV. The first semiconductor layer SCL1 may be disposed at the second end EP2 of the light emitting element and may be connected (e.g., electrically connected) to the third pixel electrode ELT3 (or the second pixel electrode ELT2).

The light emitting layer EML may be disposed around the first semiconductor layer SCL1 and may be connected (e.g., electrically connected) to the first semiconductor layer SCL1. For example, the light emitting layer EML is disposed in the groove GRV of the first semiconductor layer SCL1. The light emitting layer EML may be in contact (e.g., direct contact) with the first semiconductor layer SCL1 or may be disposed adjacent to the first semiconductor layer SCL1 with at least another semiconductor layer (for example, the third semiconductor layer SCL3 of FIG. 10) interposed therebetween.

The light emitting layer EML has a shape corresponding to the groove GRV and may be surrounded by the protrusion PRT of the first semiconductor layer SCL1. The shapes of the groove GRV and the light emitting layer EML may be variously changed or modified.

The second semiconductor layer SCL2 may be disposed around the light emitting layer EML and may be connected (e.g., electrically connected) to the light emitting layer EML. The second semiconductor layer SCL2 may be in contact (e.g., direct contact) with the light emitting layer EML or may be disposed adjacent to the light emitting layer EML with at least another semiconductor layer (for example, the fourth semiconductor layer SCL4 of FIG. 10) interposed therebetween. The second semiconductor layer SCL2 may be separated from the first semiconductor layer SCL1 with at least the light emitting layer EML interposed therebetween.

The insulating pattern layer INP is disposed at a position corresponding to the protrusion PRT of the first semiconductor layer SCL1 to surround the second semiconductor layer SCL2. The first semiconductor layer SCL1 and the second semiconductor layer SCL2 may be separated from each other by the insulating pattern layer INP and the light emitting layer EML. For example, the first semiconductor layer SCL1 and the second semiconductor layer SCL2 may be separated from each other by the insulating pattern layer INP and/or the light emitting layer EML interposed therebetween in adjacent portions, and thus a PN junction may be prevented from occurring between the first semiconductor layer SCL1 and the second semiconductor layer SCL2. Accordingly, a leakage current may be blocked or reduced.

The electrode layer ETL may be disposed at the first end EP1 of the light emitting element, and may be connected (e.g., electrically connected) to the first pixel electrode ELT1. For example, the electrode layer ETL may be disposed between the second semiconductor layer SCL2 and the first pixel electrode ELT1 to connect (e.g., electrically connect) the second semiconductor layer SCL2 and the first pixel electrode ELT1.

In concluding the detailed description, those skilled in the art will appreciate that many variations and modifications may be made to the embodiments without substantially departing from the principles and scope of the disclosure. Therefore, the disclosed embodiments are used in a generic and descriptive sense only and not for purposes of limitation.

## Claims

1. A light emitting element comprising:
a first semiconductor layer including a groove and a protrusion disposed around the groove;
a light emitting layer disposed on the groove of the first semiconductor layer, the light emitting layer having a shape corresponding to the groove;
a second semiconductor layer disposed on the light emitting layer; and
an insulating pattern layer disposed on the protrusion of the first semiconductor layer, the insulating pattern layer surrounding the second semiconductor layer.

2. The light emitting element according to claim 1, wherein the insulating pattern layer entirely surrounds the light emitting layer and the second semiconductor layer in a plan view.

3. The light emitting element according to claim 1 or claim 2, wherein the light emitting layer is disposed at a height equal to or less than a maximum height of the groove with respect to a lower surface of the first semiconductor layer.

4. The light emitting element according to any one of claims 1 to 3, wherein the second semiconductor layer and the insulating pattern layer have a same height with respect to a lower surface of the first semiconductor layer.

5. The light emitting element according to any one of claims 1 to 3, wherein
the second semiconductor layer has a height equal to or greater than a maximum height of the insulating pattern layer with respect to a lower surface of the first semiconductor layer,
a portion of the second semiconductor layer is disposed on the insulating pattern layer, and
the insulating pattern layer entirely surrounds a remaining portion of the second semiconductor layer.

6. The light emitting element according to any one of claims 1 to 5, wherein the groove comprises:
a first surface parallel to a lower surface of the first semiconductor layer; and
a second surface protruding from the first surface of the groove toward an upper surface of the first semiconductor layer.

7. The light emitting element according to claim 6, wherein the second surface of the groove includes an inclined surface inclined at an angle of less than 90 degrees with respect to the first surface of the groove.

8. The light emitting element according to claim 6, wherein the second surface of the groove is substantially perpendicular to the first surface of the groove.

9. The light emitting element according to claim 6, wherein at least one of the first surface and the second surface of the groove includes a curved surface.

10. The light emitting element according to any one of claims 1 to 5, wherein the groove has a V-shaped cross section.

11. The light emitting element according to any one of claims 1 to 5, wherein the groove has a curved shape in an entire area of the groove.

12. The light emitting element according to any one of claims 1 to 11, further comprising at least one of:
a third semiconductor layer disposed between the first semiconductor layer and the light emitting layer; and
a fourth semiconductor layer disposed between the light emitting layer and the second semiconductor layer.

13. The light emitting element according to any one of claims 1 to 12, further comprising:
an electrode layer disposed on the second semiconductor layer and the insulating pattern layer; and
an insulating film surrounding an outer circumferential surface of a light emitting stack including the first semiconductor layer, the light emitting layer, the second semiconductor layer, and the insulating pattern layer.

14. A method of manufacturing a light emitting element, the method comprising:
forming a first semiconductor layer on a substrate;
forming an insulating pattern layer on a portion of the first semiconductor layer;
forming a groove in the first semiconductor layer by etching another portion of the first semiconductor layer that is not covered by the insulating pattern layer;
forming a light emitting layer by an epitaxial growth process in the groove;
forming a second semiconductor layer on the light emitting layer;
forming a mask on the second semiconductor layer and a portion of the insulating pattern layer disposed around the second semiconductor layer;
patterning the light emitting element by etching the first semiconductor layer and the insulating pattern layer that are not covered by the mask; and
separating the light emitting element from the substrate.

15. The method according to claim 14, further comprising:
forming an electrode layer on the insulating pattern layer and the second semiconductor layer, before the forming of the mask, wherein
the forming of the mask includes forming the mask on the electrode layer overlapping the second semiconductor layer and the portion of the insulating pattern layer.
